(19) Europäisches Patentamt / European Patent Office / Office européen des brevets

(11) **EP 3 726 592 A1**

(12) **EUROPEAN PATENT APPLICATION**
published in accordance with Art. 153(4) EPC

(43) Date of publication:
**21.10.2020 Bulletin 2020/43**

(21) Application number: **18889659.1**

(22) Date of filing: **22.11.2018**

(51) Int Cl.:
*H01L 31/048* (2014.01)          *C03C 17/32* (2006.01)

(86) International application number:
**PCT/JP2018/043281**

(87) International publication number:
**WO 2019/116859 (20.06.2019 Gazette 2019/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **11.12.2017 JP 2017236991**
**13.03.2018 JP 2018045508**
**13.03.2018 JP 2018045416**

(71) Applicants:
• **AGC INC.**
**Chiyoda-ku,**
**Tokyo 1008405 (JP)**
• **AGC Glass Europe**
**1348 Louvain-La-Neuve (BE)**

(72) Inventors:
• **SAKAI Tomohiro**
**Tokyo 100-8405 (JP)**
• **SUGAWARA Yasuo**
**Tokyo 100-8405 (JP)**
• **ONOZAKI Yu**
**Tokyo 100-8405 (JP)**
• **KAYABA Noriyoshi**
**Tokyo 100-8405 (JP)**
• **KUWAHARA Yuichi**
**Tokyo 100-8405 (JP)**

(74) Representative: **Müller-Boré & Partner**
**Patentanwälte PartG mbB**
**Friedenheimer Brücke 21**
**80639 München (DE)**

(54) **OPTICAL LAYER, MANUFACTURING METHOD FOR OPTICAL LAYER, SOLAR BATTERY MODULE EQUIPPED WITH OPTICAL LAYER, EXTERNAL WALL MATERIAL FOR CONSTRUCTION, AND STRUCTURE**

(57) To provide a colored optical layer capable of forming a solar cell module excellent in the design, and the power generation efficiency and the weather resistance, a method for producing an optical layer, an optical layer-provided solar cell module, an outer wall material for building, and a building.

An optical layer having a functional layer containing an inorganic pigment and a matrix in which the inorganic pigment is dispersed, to be disposed on the side of plane of incidence of sunlight from solar cells,
wherein at least a part of the inorganic pigment is an inorganic pigment having a maximum near infrared reflectance in a near infrared region at a wavelength of from 780 to 1,500 nm of at least 50%, an average particle size of from 5.0 to 280.0 nm and a specific surface area of from 5.0 to 1,000 $m^2$/g.

Fig. 2

**Description**

TECHNICAL FIELD

The present invention relates to an optical layer, a method for producing an optical layer, an optical layer-provided solar cell module, an outer wall material for building, and a building.

BACKGROUND ART

In view of cost reduction and effective use of energy in power supply, installation of a solar cell module has been studied. In general, a solar cell module secures a power generation efficiency by using a member having a high sunlight transmittance. However, in such a case, solar cells are visually observed and can hardly harmonize with surroundings in the aspect of outer appearance in many cases.

In order to solve such a problem, attempts are being made to partially color members of a solar cell module thereby to improve the design. Patent Document 1 discloses an invention relating to a weather resistant color-toned film having a weather resistant transparent resin layer and a colored ethylene/vinyl acetate resin layer laminated and integrated, in order to impart the design to a solar cell module and to maintain the design over a long period of time.

PRIOR ART DOCUMENTS

PATENT DOCUMENTS

Patent Document 1: JP-A-2001-047568

DISCLOSURE OF INVENTION

TECHNICAL PROBLEM

However, the present inventors have found that if the design is imparted by coloring members of a solar cell module with e.g. a coloring agent, the sunlight transmittance may decrease in some cases depending upon the coloring agent used. Specifically, in the above case, the power generation efficiency of the solar cell module is inferior to a case where the members are not colored. Further, the coloring agent itself may be deteriorated by sunlight, thus lowering the weather resistance of the solar cell module. Accordingly, it has been difficult to realize a solar cell module excellent in both the design, and the power generation efficiency and the weather resistance.

Under these circumstances, it is an object of the present invention to provide an optical layer capable of forming a solar cell module excellent in the design, and the power generation efficiency and the weather resistance, a method for producing an optical layer, an optical layer-provided solar cell module, an outer wall material for building, and a building.

SOLUTION TO PROBLEM

The present inventors have conducted extensive studies to achieve the above objects and as a result, found that desired effects can be obtained by disposing an optical layer comprising a functional layer containing an inorganic pigment having predetermined physical properties and a matrix in which the inorganic pigment is dispersed, on the side of plane of incidence of sunlight of solar cells, and accomplished the present invention.

That is, the present inventors have found that the above objects can be achieved by the following constitutions.

[1] An optical layer comprising a functional layer containing an inorganic pigment and a matrix in which the inorganic pigment is dispersed, to be disposed on the side of plane of incidence of sunlight of solar cells,
wherein at least a part of the inorganic pigment is an inorganic pigment having a maximum near infrared reflectance in a near infrared region at a wavelength of from 780 to 1,500 nm of at least 50%, an average particle size of from 5.0 to 280.0 nm and a specific surface area of from 5.0 to 1,000 $m^2$/g.

[2] The optical layer according to [1], wherein the optical layer is a colored optical layer, and the above specific inorganic pigment is a colored inorganic pigment.

[3] The optical layer according to [2], wherein the colored inorganic pigment is an inorganic pigment having in the L*a*b* color space an L* value of from 5 to 100, an a* value of from -60 to 60, and a b* value of from -60 to 60.

[4] The optical layer according to [2] or [3], which further contains a light scattering inorganic pigment (excluding the colored inorganic pigment) having a minimum visible reflectance in a visible region at a wavelength of from 400 to 780 nm of at least 40%.

[5] The optical layer according to [4], wherein the light scattering inorganic pigment has a refractive index of from 1.50 to 2.60.

[6] The optical layer according to [4] or [5], wherein the light scattering inorganic pigment is an organic pigment having an average particle size of from 10.0 to 2,000 nm and a specific surface area of from 2.0 to 1,000 $m^2/g$.

[7] The optical layer according to any one of [1] to [6], wherein the matrix is at least one member selected from a fluororesin, a silicone resin, and a sintered product obtained by sintering a glass frit composition.

[8] The optical layer according to any one of [1] to [7], which has an average near infrared transmittance of from 10 to 100%, which is a value calculated by simply averaging near infrared transmittances at 5 nm intervals in a near infrared region at a wavelength of from 780 to 1,500 nm.

[9] The optical layer according to any one of [1] to [8], which further has a substrate layer, and has the functional layer laminated on at least one surface of the substrate layer.

[10] A method for producing an optical layer, which comprises applying, to at least one surface of a substrate layer, a functional layer-forming composition at least containing an inorganic pigment having a maximum near infrared reflectance in a near infrared region at a wavelength of from 780 to 1,500 nm of at least 50%, an average particle size of from 5.0 to 280.0 nm and a specific surface area of from 5.0 to 1,000 $m^2/g$, and at least one member selected from a fluorinated polymer, a silane compound and a glass frit composition, to form a functional layer thereby to form an optical layer comprising the substrate layer and the functional layer disposed on at least one surface of the substrate layer.

[11] An optical layer-provided solar cell module, comprising solar cells and the optical layer as defined in any one of [1] to [9], wherein the optical layer is disposed on the side of plane of incidence of sunlight of the solar cells.

[12] The solar cell module according to [11], wherein the solar cells are CIS solar cells or CIGS solar cells.

[13] An outer wall material for building, comprising the optical layer-provided solar cell module as defined in [11] or [12].

[14] A building comprising a solar cell module, and the optical layer as defined in any one of [1] to [9], disposed on the side of plane of incidence of sunlight of the solar cell module.

[15] An optical layer, which comprises a functional layer containing an inorganic pigment and a matrix in which the inorganic pigment is dispersed, and a substrate layer comprising a glass plate, and has the functional layer laminated on at least one surface of the substrate layer, wherein at least a part of the inorganic pigment is an inorganic pigment having a maximum near infrared reflectance in a near infrared region at a wavelength of from 780 to 1,500 nm of at least 50%, an average particle size of from 5.0 to 280.0 nm and a specific surface area of from 5.0 to 1,000 $m^2/g$.

ADVANTAGEOUS EFFECTS OF INVENTION

According to the present invention, it is possible to provide a colored optical layer capable of forming a solar cell module excellent in the design, and the power generation efficiency and the weather resistance, a method for producing an optical layer, an optical layer-provided solar cell module, an outer wall material for building, and a building.

BRIEF DESCRIPTION OF DRAWINGS

Fig. 1 is a cross-sectional view schematically illustrating an example of an optical layer of the present invention.
Fig. 2 is a cross-sectional view schematically illustrating an embodiment of an optical layer-provided solar cell module of the present invention.
Fig. 3 is a graph illustrating a sunlight spectrum on the ground and a spectral sensitivity curve of a monocrystalline silicon solar cell.
Fig. 4 is a cross-sectional schematically illustrating an embodiment of an optical layer-provided solar cell module of the present invention.
Fig. 5 is a cross-sectional schematically illustrating an embodiment of an optical layer-provided solar cell module of the present invention.
Fig. 6 is a plan view schematically illustrating an example of a solar cell array constituted by optical layer-provided solar cell modules of the present invention.

DESCRIPTION OF EMBODIMENTS

Meanings of terms in the present invention are as follows.

A colored inorganic pigment means an inorganic pigment having an absorption peak in a visible region at a wavelength of from 400 to 780 nm. A white inorganic pigment means an inorganic pigment having no absorption peak in a visible region at a wavelength of from 400 to 780 nm.

The average particle size of an inorganic pigment means a volume-based cumulative 50% diameter (D50) obtained by measurement with respect to the inorganic pigment subjected to ultrasonic treatment, by using a particle size distribution measuring apparatus, and detailed measurement conditions are as described in Examples. In Examples, as the particle size distribution measuring apparatus, Nanotrac Wave II-EX150 (manufactured by MicrotracBEL Corp.) was used.

The specific surface area of an inorganic pigment is a value obtained by nitrogen adsorption BET method at 200°C for 20 minutes under deaerated conditions, using a specific surface area measuring apparatus. In Examples, as the specific surface area measuring apparatus, HM model-1208 (manufactured by Mountech Co., Ltd.) was used.

The density of an inorganic pigment is a value obtained by measurement by a pycnometer. In Examples, ULTRAPYC 1200e (manufactured by Quantachrome) was used.

The composition of an inorganic pigment is suitably analyzed e.g. by fluorescent X-ray analysis, ICP atomic emission spectroscopy, or atomic absorption analysis.

The L* value, the a* value and the b* value of an inorganic pigment are values calculated from a diffuse reflectance spectrum obtained by measurement by diffuse reflectance method in accordance with JIS Z8781-4: 2013, and a detailed measurement method is as described in Examples.

The maximum near infrared reflectance and the minimum visible reflectance of an inorganic pigment are a maximum reflectance at a wavelength of from 780 to 1,500 nm and a minimum reflectance at a wavelength of from 400 to 780 nm, respectively, calculated from a diffuse reflectance spectrum obtained by measurement by diffuse reflectance method.

The thickness of each layer of an optical layer is suitably obtained e.g. by a thickness meter or an eddy-current instrument for measuring thickness.

The average visible transmittance and the average linear visible transmittance of an optical layer are values calculated by simply averaging visible transmittances at 5 nm intervals in a visible region at a wavelength of from 400 to 780 nm by using a spectrophotometer such that the optical layer is disposed so that light enters from the normal direction of the surface of the optical layer.

The average near infrared transmittance of an optical layer is a value calculated by simply averaging near infrared transmittances at 5 nm intervals in a near infrared region at a wavelength of from 780 to 1,500 nm by using a spectrophotometer such that the optical layer is disposed so that light enters from the normal direction of the surface of the optical layer.

The L* value, the a* value and the b* value of an optical layer are values calculated from a reflectance spectrum obtained by measuring the reflected light at 5 nm intervals at a wavelength of from 200 to 1,500 nm by using a spectrophotometer such that the optical layer is disposed so that light enters from the normal direction of the surface of the optical layer, in accordance with JIS Z8781-4: 2013.

In Examples, as the spectrophotometer, U-4100 (manufactured by Hitachi High-Technologies Corporation) was used.

A "(meth)acrylate" generally means an acrylate and a methacrylate, and "(meth)acrylic" generally means "acrylic" and "methacrylic".

The hydrolyzable silyl group is a group to be converted to a silanol group by hydrolysis.

The acid value and the hydroxy value are values measured in accordance with JIS K0070-3 (1992).

The mass of the solid content of e.g. a composition is a mass, in a case where the composition contains a solvent, having the solvent removed from the composition. The mass of the solid content of a composition is obtained as a mass remaining after the composition is heated at 130°C for 20 minutes.

According to the optical layer of the present invention, a solar cell module excellent in the design, and the power generation efficiency and the weather resistance, can be formed, which is estimated to be from the following reasons.

The optical layer of the present invention comprises a functional layer containing an inorganic pigment (hereinafter sometimes referred to as a specific inorganic pigment) having a maximum near infrared reflectance in a near infrared region at a wavelength of from 780 to 1,500 nm of at least 50%, an average particle size of from 5.0 to 280.0 nm and a specific surface area of from 5.0 to 1,000 $m^2$/g, whereby scattering of near infrared light in the optical layer is controlled, and near infrared light which is transmitted through the optical layer and can arrive at solar cells can be sufficiently secured. Accordingly, it is considered that of sunlight which entered the optical light, near infrared light is likely to selectively arrive at solar cells, and an optical layer excellent in the design and the power generation efficiency can be obtained. Further, optional coloring is possible by a colored inorganic pigment as the specific inorganic pigment, whereby the optical layer is excellent in the design and is excellent in the weather resistance as well.

Now, an example of the optical layer of the present invention and the optical layer-provided solar cell module of the present invention will be described with reference to drawings. The optical layer of the present invention will sometime be referred to as the present optical layer, and the optical layer-provided solar cell module of the present invention will sometimes be referred to as the present solar cell module.

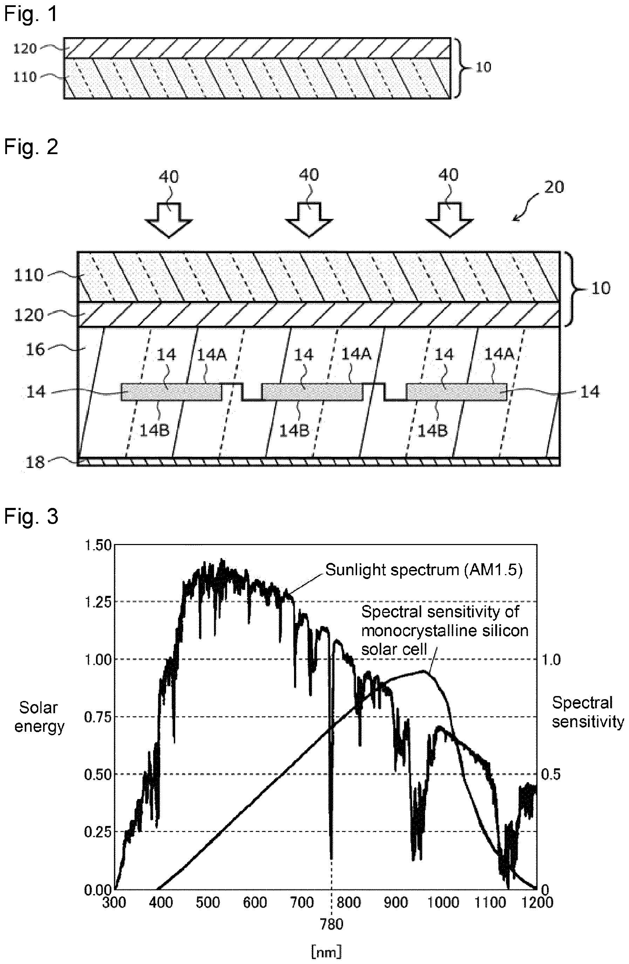

Fig. 1 is a cross-sectional view schematically illustrating an example of the present optical layer.

As shown in Fig. 1, the present optical layer 10 comprises a substrate layer 110 and a functional layer 120.

The present optical layer is preferably a colored optical layer containing the specific inorganic pigment, particularly preferably a colored optical layer containing a colored inorganic pigment as the specific inorganic pigment. Hereinafter, the specific inorganic pigment which is a colored inorganic pigment will sometimes be referred to as a specific colored inorganic pigment. The specific colored inorganic pigment may be used in combination with a white specific inorganic pigment, or may be used in combination with a white pigment other than the specific inorganic pigment.

The present optical layer which is colored is colored since it contains the specific colored inorganic pigment and contributes to the design of the present solar cell module. The present optical layer being colored specifically means an average visible transmittance being at most 90%.

The present optical layer preferably has, in view of the design, a functional layer having in the L*a*b* color space an L* value of from 5 to 100, an a* value of from -60 to 60 and a b* value of from -60 to 60, more preferably an L* value of from 15 to 80, an a* value of from 3 to 30 and a b* value of from -60 to 60.

The present optical layer is, in order to achieve the desired color, particularly preferably a layer having the following combination of the L* value, the a* value and the b* value.

- An optical layer having an L* value, an a* value and a b* value of from 5 to 100, from -10 to 10 and from -15 to 10 in this order (more preferably from 15 to 60, from 1.5 to 15 and from -10 to 10 in this order).
- An optical layer having an L* value, an a* value and a b* value of from 25 to 70, from 0 to 30 and from -60 to -20 in this order.
- An optical layer having an L* value, an a* value and a b* value of from 20 to 70, from 0 to 40 and from -20 to 30 in this order.
- An optical layer having an L* value, an a* value and a b* value of from 30 to 80, from -20 to 20 and from 0 to 60 in this order.

The present optical layer, which comprises the after-described functional layer containing an inorganic pigment and a matrix, has a brighter color and achieves more excellent design of the present solar cell module, when the L* value, the a* value and the b* value are within the above combination.

The present optical layer has, in view of the power generation efficiency of the present solar cell module, an average near infrared transmittance which is a value calculated by simply averaging near infrared transmittances at 5 nm intervals in a near infrared region at a wavelength of from 780 to 1,500 nm, of preferably at least 10%, more preferably at least 30%, further preferably at least 40%, particularly preferably at least 60%. The average near infrared transmittance of the present optical layer is usually at most 100%.

The present optical layer has, in view of shielding properties of the present optical layer, an average visible transmittance which is a value calculated by simply averaging visible transmittances at 5 nm intervals in a visible region at a wavelength of from 400 to 780 nm, of preferably at most 80%, more preferably at most 50%, further preferably at most 42.0%, particularly preferably at most 20%.

The average near infrared transmittance and the average visible transmittance of the present optical layer may be adjusted, for example, e.g. by the type or the addition amount of the specific inorganic pigment or the after-described light scattering inorganic pigment, or the thickness of the present optical layer.

The methods for measuring the near infrared transmittance and the average visible transmittance of the present optical layer are as described above, and detailed measurement conditions are as described in the after-described Examples.

The thickness of the present optical layer is, in view of handling efficiency of the present solar cell module, preferably at least 10 μm, more preferably from 20 μm to 100 mm, particularly preferably from 100 μm to 50 mm.

The functional layer in the present invention contains an inorganic pigment of which at least a part is a specific inorganic pigment, and a matrix in which the inorganic pigment is dispersed. The functional layer may contain at least one component other than the inorganic pigment and the matrix.

Of the functional layer, the L* value, the a* value and the b* value and their preferred ranges are the same as those of the optical layer as described above.

Of the functional layer, the average near infrared transmittance and the average visible transmittance and their preferred ranges are the same as those of the optical layer as described above.

That is, in a case where the present optical layer has the functional layer and a layer other than the functional layer, the layer other than the functional layer is preferably a layer which does not affect the average near infrared transmittance and the average visible transmittance of the present optical layer. "Does not affect" specifically means that the difference in the average near infrared transmittance and the difference in the average visible transmittance between an optical layer having no layer other than the functional layer and an optical layer having a layer other than the functional layer, are respectively less than 10%, preferably less than 5%.

The functional layer has, in view of the weather resistance of the functional layer, a thickness of preferably from 1 to 1,000 $\mu$m, more preferably from 10 to 1,000 $\mu$m, further preferably from 20 to 100 $\mu$m, particularly preferably from 25 to 60 $\mu$m.

The specific inorganic pigment in the present invention has a maximum near infrared reflectance in a near infrared region at a wavelength of from 780 to 1,500 nm of at least 50%, an average particle size of from 5.0 to 280.0 nm, and a specific surface area of from 5.0 to 1,000 m$^2$/g.

The maximum near infrared reflectance in a near infrared region at a wavelength of from 780 to 1,500 nm of the specific inorganic pigment is, in view of the near infrared transmittance of the present optical layer, at least 50%, preferably at least 60%, more preferably at least 70%, particularly preferably at least 80%. The upper limit of the maximum near infrared reflectance is usually 100%.

The maximum near infrared reflectance of the specific inorganic pigment may properly be adjusted by the type, composition and crystal structure of the inorganic pigment.

In the present invention, the specific colored inorganic pigment is used to make the functional layer in the present invention be colored, and accordingly an inorganic pigment which does not make the functional layer be colored when used alone does not belong to the category of the colored inorganic pigment. That is, a white inorganic pigment such as silicon oxide (particularly silicon dioxide) does not fall into the category of the colored inorganic pigment. Further, the functional layer being colored means that the functional layer having an average visible transmittance of at most 90%.

The average particle size of the specific inorganic pigment is at least 5.0 nm, preferably at least 50.0 nm, particularly preferably at least 100.0 nm. The average particle size of the inorganic pigment is at most 280.0 nm, preferably at most 200.0 nm, more preferably at most 180.0 nm, further preferably at most 160.0 nm, particularly preferably at most 140.0 nm.

When the average particle size of the specific inorganic pigment is at most 280.0 nm, the present optical layer has a high near infrared transmittance, and the present solar cell module is excellent in the power generation efficiency. When the average particle size of the specific inorganic pigment is at least 1.0 nm, the present optical layer is excellent in shielding properties, and the present solar cell module is excellent in the design.

The specific surface area of the specific inorganic pigment is at least 5.0 m$^2$/g, preferably at least 10.0 m$^2$/g, more preferably at least 15.0 m$^2$/g, particularly preferably at least 40.0 m$^2$/g. The specific surface area of the inorganic pigment is at most 1,000 m$^2$/g, preferably at most 500 m$^2$/g, particularly preferably at most 60.0 m$^2$/g.

When the specific surface area of the specific inorganic pigment is at least 5.0 m$^2$/g and at most 1,000 m$^2$/g, scattering of near infrared light by the inorganic pigment is favorable, and the present solar cell module is excellent in the power generation efficiency.

Of the specific inorganic pigment, a particularly preferred combination of the maximum near infrared reflectance, the average particle size and the specific surface area is as follows.

- An inorganic pigment having a maximum near infrared reflectance of at least 60%, an average particle size of from 50.0 to 200.0 nm and a specific surface area of from 10.0 to 500 m$^2$/g.
- An inorganic pigment having a maximum near infrared reflectance of at least 70%, an average particle size of from 100.0 to 180.0 nm and a specific surface area of from 15.0 to 60 m$^2$/g.

The particle shape of the specific inorganic pigment is not particularly limited. The specific inorganic pigment may have any particle shape, for example, spherical, elliptic, needle, plate, rod, conical, columnar, cubical, cuboidal, diamond, star, scaly or irregular shape. Further, the specific inorganic pigment may be hollow particles or may be solid particles. Further, the specific inorganic pigment may be porous particles.

The specific inorganic pigment is preferably spherical in view of dispersibility.

The specific inorganic pigment is, in view of the design and the weather resistance of the present optical layer, preferably composed of e.g. a metal oxide or a hydrate of a metal oxide, particularly preferably a metal composite oxide containing at least two types of metal elements.

The metal element may, for example, be Li, Na, Mg, K, Ca, Al, Si, Ti, V, Cr, Mn, Fe, Co, Ni, Cu, Zn, Sr, Y, Zr, Nb, Mo, Cd, In, Sn, Sb, Ba, Ta, W, Pb, Bi, La or Ce. The metal element is, in view of the near infrared reflectance of the specific inorganic pigment, and the color tone and the power generation efficiency of the present optical layer, preferably Al, Fe, Co, Zn, Zr, Mn, Cr, Ce, Bi, Ni, Cu or Cd, more preferably Al, Fe, Co, Zr, Ce, Mn, Bi or Cu, further preferably Al, Fe, Co, Zn or Zr, particularly preferably Al, Fe or Co.

With a view to suppressing deterioration by the photocatalytic action, a part of or the entire metal oxide or its hydrate constituting the specific inorganic pigment may further be surface-treated with the same or different type of metal oxide or its hydrate (such as silicon oxide or aluminum oxide).

The specific inorganic pigment may be composed solely of the metal oxide or may contain other component. The component other than the metal oxide may, for example, be an organic compound. The specific inorganic pigment, in view of the weather resistance of the present optical layer, preferably contains no other component or contains other component in a proportion of at most 50 mass% to the total mass of the inorganic pigment.

The specific inorganic pigment containing other component may be an inorganic pigment having a part of or the entire particles of the metal oxide surface-treated with e.g. an organic compound.

The specific colored inorganic pigment may, for example, be specifically a Co-Ni-Ti-Zn composite oxide, a Co-Li composite oxide, a Co-Al composite oxide, a Ti-Sb-Ni composite oxide, a Co-Zn-Si composite oxide, a Co-Al-Cr composite oxide, a Co-Al-Cr-Zn composite oxide, a Co-Cr-Zn-Ti composite oxide, a Ti-Fe-Zn composite oxide, a Fe-Zn composite oxide, a Fe-Cr composite oxide, a Mn-Bi composite oxide, a Cu-Bi composite oxide, a Cu-Fe-Mn composite oxide, an iron oxide or a hydrate of an iron oxide. The specific colored inorganic pigment is, in view of the dispersibility and the near infrared reflectance of the inorganic pigment, and the shielding properties and the near infrared transmittance of the present optical layer, preferably a Co-Li composite oxide, a Co-Al composite oxide, a Co-Al-Cr composite oxide, a Fe-Cr composite oxide, a Mn-Bi composite oxide, a Cu-Bi composite oxide, a Cu-Fe-Mn composite oxide, an iron oxide or a hydrate of an iron oxide, more preferably a Co-Al composite oxide or an iron oxide, particularly preferably a Co-Al composite oxide or an iron oxide.

As the specific colored inorganic pigment, commercial products may be used, such as "Daipyroxide TM" series (manufactured by Dainichiseika Color & Chemicals Mfg Co., Ltd.), "Cappoxyt" series (manufactured by Cappelle), "Sicotrans" series (manufactured by BASF) and "Blue CR4" (manufactured by ASAHI KASEI KOGYO CO., LTD.

The colored inorganic pigment which is white may, for example, be specifically titanium oxide, zirconium oxide, vanadium oxide, zinc oxide, indium oxide, tin oxide, silicon oxide or aluminum oxide, and in view of the shielding properties of the present optical layer and the power generation efficiency of the present solar cell module, it is preferably titanium oxide, zirconium oxide or zinc oxide, particularly preferably zirconium oxide.

With a view to suppressing deterioration by photocatalytic action, a part of or the entire metal oxide constituting the specific inorganic pigment which is white may further be surface-treated with the same or different type of metal oxide (such as silicon oxide or aluminum oxide).

In a case where the weather resistance of the present optical layer is to be more improved, for the purpose of preventing deterioration by photocatalytic action, the specific inorganic pigment preferably contains no titanium oxide or contains titanium oxide in a proportion of less than 1 mass% in the entire inorganic pigment.

As the specific inorganic pigment which is white, commercial products may be used, such as "TTO" series (manufactured by Ishihara Sangyo Kaisha, Ltd.), "MT" series (manufactured by TAYCA CORPORATION), "FINEX" series (manufactured by SAKAI CHEMICAL INDUSTRY CO., LTD.), XZ-F series (manufactured by SAKAI CHEMICAL INDUSTRY CO., LTD.) and "ZIRCOSTAR" series (manufactured by NIPPON SHOKUBAI CO., LTD.).

The specific colored inorganic pigment has, in view of the design of the present optical layer, in the L*a*b* color space an L* value of from 5 to 100, an a* value of from - 60 to 60 and a b* value of from -60 to 60, more preferably an L* value of from 15 to 80, an a* value of from 0.0 to 3.0 and a b* value of from -60 to 60.

The specific colored inorganic pigment, in order that the present optical layer has a desired color, the following combination of the L* value, the a* value and the b* value.

- An inorganic pigment having an L* value, an a* value and a b* value of from 30 to 70, from 0.0 to 30 and from -60 to -20 in this order.
- An inorganic pigment having an L* value, an a* value and a b* value of from 20 to 70, from 0.0 to 40 and from -20 to 30 in this order.
- An inorganic pigment having an L* value, an a* value and a b* value of from 30 to 80, from -20 to 20 and from 0 to 60 in this order.
- An inorganic pigment having an L* value, an a* value and a b* value of from 80 to 100, from -10 to 10 and from -10 to 10 in this order.
- An inorganic pigment having an L* value, an a* value and a b* value of from 5 to 50, from -10 to 10 and from -10 to 10 in this order.

The L* value, the a* value and the b* value of the inorganic pigment may be adjusted e.g. by the composition of the above-described specific colored inorganic pigment.

The density of the specific colored inorganic pigment is, in view of the dispersibility of the inorganic pigment, preferably from 2.0 to 10.0 $g/cm^3$, particularly preferably from 3.0 to 5.0 $g/cm^3$.

The density of the specific inorganic pigment which is white is, in view of the dispersibility of the inorganic pigment, preferably from 0.10 to 10.0 $g/cm^3$, particularly preferably from 5.0 to 7.0 $g/cm^3$.

The refractive index of the specific inorganic pigment is, in order that the functional layer more selectively transmits near infrared light, preferably at most 4.00, more preferably at least 1.50 and at most 3.00, further preferably at least 1.90 and at most 2.60, particularly preferably at least 2.10 and at most 2.40.

The refractive index of the specific inorganic pigment which is white is, in order that the functional layer more selectively transmits near infrared light, preferably at most 4.00, more preferably from 1.50 to 3.00, further preferably from 1.90 to 2.60, particularly preferably from 2.10 to 2.40.

The refractive index of an inorganic pigment means a refractive index of the material constituting the inorganic pigment (for example, in a case where the inorganic pigment is obtained by pulverizing the material, the material before pulverizing), and is usually a value regarding the above material disclosed in literature.

The minimum visible reflectance and the refractive index of the inorganic pigment may be properly adjusted by the composition, crystal structure, average particle size and specific surface area of the inorganic pigment.

The content of the specific inorganic pigment to the total mass of the functional layer is, in view of the design of the present optical layer, preferably at least 5 mass%, more preferably at least 10 mass%, particularly preferably at least 20 mass%. The content of the specific inorganic pigment to the total mass of the functional layer is, in view of the near infrared transmittance of the present optical layer, preferably at most 80 mass%, more preferably at most 60 mass%, particularly preferably at most 50 mass%.

The proportion of the specific inorganic pigment to the total mass of the inorganic pigment contained in the functional layer is, in view of the design and the power generation efficiency, preferably at least 80 mass%, particularly preferably at least 90 mass%.

The functional layer may contain two or more types of specific inorganic pigment. In a case where the specific colored inorganic pigment and the specific inorganic pigment which is white are used in combination, the proportion of the specific inorganic pigment which is white to the total amount of such specific inorganic pigments is preferably from 5 to 200 mass%, more preferably from 20 to 150 mass%, particularly preferably from 20 to 40 mass%. When the functional layer contains the specific colored inorganic pigment in a larger amount than the specific inorganic pigment which is white, the shielding properties of the present optical layer and the design of the present solar cell module will be well balanced.

Particularly, the specific inorganic pigment which is white is also a light scattering inorganic pigment having a minimum visible reflectance in a visible region at a wavelength of from 400 to 780 nm of at least 40%. Accordingly, by mixing the specific colored inorganic pigment and the specific inorganic pigment which is white, the present solar cell module is more excellent in shielding properties.

The specific inorganic pigment which is white has, in order that the functional layer more selectively scatters visible light, a minimum visible reflectance in a visible region at a wavelength of from 400 to 780 nm of at least 40%, preferably at least 80%, more preferably at least 90%, particularly preferably at least 95%. The upper limit of the minimum visible reflectance is usually 100%.

The specific inorganic pigment in the present invention hardly scatters near infrared light in sunlight. And, it is likely to improve the design since it has sufficient absorption in a visible region. Further, it is excellent in the weather resistance as compared with the organic pigment and has the above average particle size and specific surface area and is thereby likely to be suitably dispersed in the functional layer. Accordingly, the present optical layer comprising the functional layer containing the inorganic pigment in the present invention is considered to have high shielding property and be excellent in the weather resistance and further be excellent in the design and the power generation efficiency when applied to a solar cell module.

The functional layer may further contain, in view of the design of the present solar cell module, a light scattering inorganic pigment (excluding the specific inorganic pigment) having a minimum visible reflectance in a visible region at a wavelength of from 400 to 780 nm of at least 40%. Such a light scattering inorganic pigment other than the specific inorganic pigment will hereinafter sometimes be referred to as a light scattering inorganic pigment.

Of the light scattering inorganic pigment, the minimum visual reflectance in a visible region at a wavelength of from 400 to 780 nm, the refractive index, the density, the shape and their preferred ranges are the same as those of the specific inorganic pigment which is white as described above. The light scattering inorganic pigment is constituted by the same metal oxide or the like as the specific inorganic pigment which is white or flakey inorganic pigment having a structural color and is preferably a white inorganic pigment.

The average particle size of the light scattering inorganic pigment is preferably at least 10.0 nm, more preferably at least 50.0 nm, particularly preferably at least 100.0 nm. The average particle size of the light scattering inorganic pigment is preferably at most 2,000 nm, more preferably at most 500.0 nm, particularly preferably at most 300.0 nm.

When the average particle size of the light scattering inorganic pigment is at most 2,000 nm, the present optical layer has a high near infrared transmittance, and the present solar cell module is excellent in the power generation efficiency. When the average particle size of the light scattering inorganic pigment is at least 10 nm, it is excellent in the scattering of visible light.

The specific surface area of the light scattering inorganic pigment is preferably at least 2.0 $m^2$/g, particularly preferably at least 8.0 $m^2$/g. The specific surface area of the light scattering inorganic pigment is preferably at most 1,000 $m^2$/g, particularly preferably at most 500 $m^2$/g.

When the specific surface area of the light scattering inorganic pigment is at most 1,000 $m^2$/g, scattering of visible light increases, and accordingly the present optical layer tends to have a high near infrared transmittance. When the specific surface area of the light scattering inorganic pigment is at least 2.0 $m^2$/g, the present optical layer tends to have a high near infrared transmittance.

The light scattering inorganic pigment may be a flaky inorganic pigment (pearl pigment) having a structural color in view of design of the present solar cell module.

The pearl pigment is a pigment comprising flaky particles (for example, particles having a maximum size of from 2 to 100 $\mu$m and a thickness of from 0.01 to 10 $\mu$m) the surface of which is coated with a metal or its oxide. The flaky particles may be composed of mica, sericite, talc, kaolin, smectite clay mineral, mica, sericite, plate-like titanium dioxide, plate-like silica, plate-like aluminum oxide, boron nitride, barium sulfate, plate-like titania/silica composite oxide, glass or the like. The metal or its oxide coating the surface of the flaky particles may be the metal or its oxide mentioned for the above inorganic pigment. The pearl pigment is preferably flaky particles comprising mica, glass, aluminum oxide or the like, the surface of which is covered with titanium dioxide, iron oxide, silver or the like.

In a case where the functional layer contains the pearl pigment as the light scattering inorganic pigment, it can achieve a brighter and more glittering color tone, and the present solar cell module is more excellent in the design.

The pearl pigment may, for example, be METASHINE titania coated series (manufactured by Nippon Sheet Glass Co., Ltd.) or TWINCLEPEARL silver type (manufactured by NIHON KOKEN KOGYO CO., LTD.).

In a case where the functional layer contains the light scattering inorganic pigment, the content of the light scattering inorganic pigment to the total mass of the functional layer is, in view of the near infrared transmittance of the functional layer, preferably from 1 to 90 mass%, more preferably from 3 to 80 mass%, particularly preferably from 5 to 60 mass%. In such a case, the present optical layer is particularly excellent in the shielding properties and the near infrared transmittance.

In a case where the functional layer contains a light scattering inorganic pigment, the functional layer may contain two or more types of light scattering inorganic pigment.

In a case where the functional layer contains the light scattering inorganic pigment, the content of the light scattering inorganic pigment is preferably at most 100 mass%, particularly preferably at most 10 mass% to the total mass of the specific inorganic pigment contained in the functional layer. In such a case, the shielding properties of the present optical layer and the design of the present solar cell module will be balanced.

In a case where the functional layer contains both the light scattering inorganic pigment and the specific inorganic pigment, the total content of the light scattering inorganic pigment and the specific inorganic pigment in the functional layer is preferably at least 5 mass% and at most 80 mass%, particularly preferably at least 20 mass% and at most 50 mass%, to the total mass of the functional layer. In such a case, the present optical layer is particularly excellent in the shielding properties and the near infrared transmittance.

The matrix in the present invention has a function to fix the inorganic pigment in a dispersed state. The component constituting the matrix may, for example, be a resin, glass obtained by sintering a glass frit composition, or silica. The matrix may be constituted by two or more of the above components.

The resin constituting the matrix may be a thermoplastic resin or a cured product of a curable resin. A crosslinked product of a polymer having crosslinkable groups, a condensation polymerization product of a compound having condensation-polymerizable groups, an addition-polymerized product of a compound having addition-polymerizable groups and the like also fall into the category of the thermoplastic resin and the cured product of a curable resin. Further, a thermoplastic resin having reactive groups such as hydroxy groups may act as the resin constituting the matrix without reaction of the reactive groups.

The thermoplastic resin or an uncured curable resin for forming the resin constituting the matrix properly contains components necessary for forming the matrix resin (for example, the after-described component X such as a curing agent).

The resin forming the matrix may, for example, be an alkyd resin, an amino alkyd resin, a polyester resin, an epoxy resin, an urethane resin, an epoxy-polyester resin, a vinyl acetate resin, an acrylic resin, a vinyl chloride resin, a phenol resin, a modified polyester resin, a fluororesin, an acrylic silicone resin, a silicone resin, an ethylene/vinyl acetate resin, or a polyvinyl butyral resin. Among them, the resin to be the resin constituting the matrix by curing or crosslinking is a resin the cured product or crosslinked product of which constitutes the matrix. The resin constituting the matrix is, in view of the weather resistance, preferably a fluororesin comprising a fluorinated polymer or a crosslinked product of a crosslinkable fluorinated polymer, and in view of the heat resistance, preferably a silicone resin comprising a condensation polymerization product of a condensation-polymerizable silane compound.

The matrix may be constituted by two or more types of resin.

In a case where the matrix in the present invention contains a fluororesin, the fluororesin to be used for forming the matrix contains a fluorinated polymer having units based on a fluoroolefin (hereinafter sometimes referred to as units F) and as the case requires, at least one component X other than the fluorinated polymer described hereinafter.

A unit generally means an atomic group based on one monomer molecule directly formed by polymerization of the monomer, and an atomic group obtained by chemical conversion of a part of the atomic group. The content (mol%) of each units to all the units in a polymer is obtained by analyzing the polymer by nuclear magnetic resonance (NMR) spectroscopy.

A fluoroolefin is an olefin having at least one hydrogen atom substituted by a fluorine atom. In the fluoroolefin, at least one hydrogen atom not substituted by a fluorine atom may be substituted by a chlorine atom.

The fluoroolefin may, for example, be specifically $CF_2=CF_2$, $CF_2=CFCl$, $CF_2=CHF$, $CH_2=CF_2$, $CF_2=CFCF_3$, $CF_2=CHCF_3$, $CF_3CH=CHF$, $CF_3CF=CH_2$ or a monomer represented by $CH_2=CX^{f0}(CF_2)_{n0}Y^{f0}$ (wherein $X^{f0}$ and $Y^{f0}$ are each independently a hydrogen atom or a fluorine atom, and n0 is an integer of from 2 to 10), and in view of excellent weather resistance of the functional layer, preferably $CF_2=CF_2$, $CH_2=CF_2$, $CF_2=CFCl$, $CF_3CH=CHF$, $CF_3CF=CH_2$, particularly preferably $CF_2=CFCl$. The fluoroolefin may be used in combination of two or more.

The fluorinated polymer may have only units F, may have units F and units based on a monomer containing a fluorine atom other than the fluoroolefin, or may have units F and units based on a monomer containing no fluorine atom.

The fluorinated polymer having only units F may, for example, be a homopolymer of the fluoroolefin or a copolymer of at least two types of fluoroolefin, specifically, polytetrafluoroethylene, polychlorotrifluoroethylene, a tetrafluoroethylene/hexafluoropropylene copolymer or polyvinylidene fluoride.

The fluorinated polymer having units F and units based on a monomer containing a fluorine atom other than the fluoroolefin may, for example, be a fluoroolefin/perfluoro(alkyl vinyl ether) copolymer, specifically, a tetrafluoroethylene/perfluoro(alkyl vinyl ether) copolymer.

The fluorinated polymer preferably has units F and units based on a monomer containing no fluorine atom, in view of the dispersibility of the inorganic pigment in the matrix.

The fluorinated polymer having units F and units based on a monomer containing no fluorine atom may, for example, be a chlorotrifluoroethylene/vinyl ether copolymer, a chlorotrifluoroethylene/vinyl ether/vinyl ester copolymer, a chlorotrifluoroethylene/vinyl ester/allyl ether copolymer, a tetrafluoroethylene/vinyl ester copolymer, a tetrafluoroethylene/vinyl ester/allyl ether copolymer or an ethylene/tetrafluoroethylene copolymer. It is preferably a chlorotrifluoroethylene/vinyl ether copolymer, whereby the present solar cell module is excellent in the design.

The content of the units F is, in view of the weather resistance of the functional layer, preferably from 20 to 100 mol%, more preferably from 30 to 70 mol%, particularly preferably from 40 to 60 mol%, to all the units contained in the fluorinated polymer.

The fluorinated polymer preferably has, in view of the durability of the functional layer, as the units based on a monomer containing no fluorine atom, units having a crosslinkable group (hereinafter sometimes referred to as units (1)). The units (1) may be units based on a monomer having a crosslinkable group (hereinafter sometimes referred to as a monomer (1)) or may be units obtained by converting crosslinkable groups of a fluorinated polymer having units (1) to different crosslinkable groups. Such units may be units obtained by reacting a fluorinated polymer having units having a hydroxy group with a polycarboxylic acid or its acid anhydride or the like to convert one or more or all of the hydroxy groups to carboxy groups. The crosslinkable group may be a hydroxy group, a carboxy group, an amino group, an epoxy group or a hydrolyzable silyl group, and is preferably a hydroxy group or a carboxy group in view of the strength of the functional layer.

The crosslinkable group which the unit (1) has may be crosslinked by the after-described curing agent in the matrix formed, or may remain without being crosslinked, and is preferably crosslinked with the curing agent. When the crosslinkable group which the unit (1) has is crosslinked by the curing agent, the functional layer is more excellent in durability. When the crosslinkable group which the unit (1) has remains without being crosslinked, the dispersibility of the inorganic pigment in the matrix is more excellent.

The monomer having a hydroxy group may, for example, be a vinyl ether, a vinyl ester, an allyl ether, an allyl ester, a (meth)acrylic acid ester or allyl alcohol, having a hydroxy group.

The monomer (1) having a hydroxy group may, for example, be specifically $CH_2=CHO-CH_2-cycloC_6H_{10}-CH_2OH$, $CH_2=CHCH_2O-CH_2-cycloC_6H_{10}-CH_2OH$, $CH_2=CHO-CH_2-cycloC_6H_{10}-CH_2-(OCH_2CH_2)_{15}OH$, $CH_2=CHOCH_2CH_2OH$, $CH_2=CHCH_2OCH_2CH_2OH$, $CH_2=CHOCH_2CH_2CH_2CH_2OH$ or $CH_2=CHCH_2OCH_2CH_2CH_2OH$, and in view of copolymerizability with the fluoroolefin, preferably $CH_2=CHCH_2OCH_2CH_2OH$ or $CH_2=CHOCH_2CH_2CH_2CH_2OH$. "-cycloC_6H_{10}-" represents a cyclohexylene group, and the binding position of "-cycloC_6H_{10}-" is usually 1,4-position.

The monomer having a carboxy group may, for example, be an unsaturated carboxylic acid, a (meth)acrylic acid, or a monomer obtained by reacting the hydroxy group of the monomer having a hydroxy group with a carboxylic anhydride.

The monomer having a carboxyl group may, for example, be specifically $CH_2=CHCOOH$, $CH(CH_3)=CHCOOH$, $CH_2=C(CH_3)COOH$, $HOOCCH=CHCOOH$, a monomer represented by $CH_2=CH(CH_2)_{n11}COOH$ (wherein n11 is an integer of from 1 to 10), a monomer represented by $CH_2=CHO(CH_2)_{n12}OC(O)CH_2CH_2COOH$ (wherein n12 is an integer of from 1 to 10), and in view of copolymerizability with the fluoroolefin, preferably a monomer represented by $CH_2=CH(CH_2)_{n11}COOH$ or a monomer represented by $CH_2=CHO(CH_2)_{n12}OC(O)CH_2CH_2COOH$.

The monomer (1) may be used in combination of two or more.

The content of the units (1) is preferably from 0.5 to 35 mol%, more preferably from 3 to 25 mol%, further preferably from 5 to 25 mol%, particularly preferably from 5 to 20 mol%, to all the units contained in the fluorinated polymer.

The fluorinated polymer may further have, as the units based on a monomer containing no fluorine atom, units based on a monomer having no crosslinkable group. The units based on a monomer having no crosslinkable group may be units (hereinafter sometimes referred to as units (2)) based on at least one monomer (hereinafter sometimes referred to as a monomer (2)) selected from the group consisting of an alkene, a vinyl ether, a vinyl ester, an allyl ether, an allyl ester and a (meth)acrylic acid ester.

The monomer (2) may, for example, be specifically ethylene, propylene, 1-butene, ethyl vinyl ether, tert-butyl vinyl ether, 2-ethylhexyl vinyl ether, cyclohexyl vinyl ether, vinyl acetate, vinyl pivalate, vinyl neononanoate (manufactured by HEXION, trade name "VeoVa 9"), vinyl neodecanoate (manufactured by HEXION, trade name "VeoVa 10"), vinyl benzoate, vinyl tert-butylbenzoate, tert-butyl (meth)acrylate or benzyl (meth)acrylate.

The monomer (2) may be used in combination of two or more.

In a case where the fluorinated polymer contains the units (2), the content of the units (2) is preferably from 5 to 60 mol%, particularly preferably from 10 to 50 mol% to all the units contained in the fluorinated polymer.

As the fluorinated polymer, commercial products may be used, specific examples of which include "LUMIFLON" series (trade name by AGC Inc.), "Kynar" series (trade name by Arkema), "ZEFFLE" series (trade name by DAIKIN INDUSTRIES, LTD.), "Eterflon" series (trade name by Eternal Materials Co., Ltd.) and "Zendura" series (trade name by Honeywell).

The fluorinated polymer is produced by a known method. As a method for producing the fluorinated polymer, solution polymerization, emulsion polymerization or the like may be mentioned.

As the component other than the fluorinated polymer contained in the fluororesin, a polymerization stabilizer, a polymerization inhibitor, a surfactant or the like, which is optionally added at the time of production or after production of the fluorinated polymer may be mentioned.

In a case where the matrix in the present invention contains the fluororesin, the content of the fluororesin in the functional layer is, in view of the weather resistance of the functional layer, preferably from 5 to 95 mass%, particularly preferably from 10 to 90 mass%, to the total mass of the functional layer.

In a case where the matrix in the present invention contains the fluororesin, the content of the fluorinated polymer in the functional layer is, in view of the weather resistance of the functional layer, preferably from 5 to 95 mass%, particularly preferably from 10 to 90 mass%, to the total mass of the functional layer.

In a case where the matrix in the present invention contains the fluororesin, the fluorine atom content in the functional layer is, in view of the dispersibility of the inorganic pigment in the matrix, preferably at most 65 mass%, more preferably at most 50 mass%, particularly preferably at most 40 mass%, further preferably at most 25 mass%, most preferably at most 20%. Further, the fluorine atom content in the functional layer is, in view of the weather resistance of the functional layer, preferably at least 0.1 mass%, more preferably at least 3 mass%, particularly preferably at least 5 mass%, further preferably at least 10 mass% to the total mass of the functional layer.

In such a case, particularly when the fluorine atom content in the functional layer is preferably from 0.1 to 25 mass%, particularly preferably from 5 to 20 mass%, the inorganic pigment is favorably dispersed in the functional layer, and the present optical layer has a high near infrared transmittance and a high visible reflectance, whereby the present solar cell module is excellent in the design and the power generation efficiency.

The fluorine atom content in the functional layer means the content (mass%) of fluorine atoms to all the atoms constituting the functional layer. The fluorine atom content in the functional layer is obtained by measurement by automatic quick furnace combustion ion chromatography (AQF-IC) under the following conditions.

<Analytical conditions>

•Automatic quick furnace combustion apparatus

Apparatus: manufactured by Mitsubishi Chemical Analytech Co., Ltd., automatic quick furnace combustion apparatus AQF-100

Combustion conditions: solid sample mode

Sample amount: 2 to 20 mg

Ion chromatograph

Apparatus: manufactured by Thermo Fischer SCIENTIFIC

Column: Ionpac AG11HC + Ionpac AS11HC

Eluent: KOH 10 mN (0 to 9 min), 10 to 16 mN (9 to 11 min), 16 mN (11 to 15 min), 16 to 61 mN (15 to 20 min), 60 mN (20 to 25 min)

Flow rate: 1.0 mL/min

Suppressor: ASRS

Detector: conductance detector

Amount injected: 5 μL

In a case where the matrix in the present invention is a silicone resin, the silicone resin contains a hydrolyzed condensate of a silane compound and as the case requires, at least one component X other than the hydrolyzed condensate of a silane compound, described hereinafter.

The silane compound may, for example, be a chlorosilane, a silazane or an alkoxysilane, and in view of the reactivity of the silane compound, preferably an alkoxysilane.

The chlorosilane may, for example, be trichlorosilane or trimethyl chlorosilane.

The silazane may, for example, be hexamethyl disilazane or heptamethyl disilazane.

The alkoxysilane has at least one alkoxy group directly bonded to the silicon atom. The alkoxysilane may have at least one group directly bonded to the silicon atom, other than the alkoxy group. Further, the alkoxysilane may have a hydrogen atom.

As the alkoxysilane, in view of durability of the functional layer, it is preferred to use a tetraalkoxysilane having 4 alkoxy groups directly bonded to the silicon atom, and an alkoxysilane having from 1 to 3 alkoxy groups directly bonded to the silicon atom, in combination.

As at least one group directly bonded to the silicon atom, other than the alkoxy group, a hydroxy group, an alkyl group, an aromatic alkyl group, a vinyl group, an epoxy group, a styryl group, a (meth)acrylic group, an amino group, an isocyanate group, a mercapto group, a ureido group, a polyfluoropolyether group or a polyfluoroalkyl group, may, for example, be mentioned, and in view of crack resistance of the silicone resin, an alkyl group or an aromatic alkyl group is preferred.

The alkyl group may, for example, be a methyl group, an ethyl group, a propyl group, a hexyl group or an octyl group, and is preferably a methyl group, an ethyl group or a propyl group.

The aromatic alkyl group may, for example, be an aryl group or a phenyl group, and is preferably a phenyl group.

As at least one group directly bonded to the silicon atom, other than the alkoxy group, in view of hardness of the functional layer, a methyl group, an ethyl group, a propyl group or a phenyl group is preferred.

The alkoxysilane may, for example, be specifically tetramethoxysilane, tetraethoxysilane, tetrapropoxysilane, tetrabutoxysilane, methyltrimethoxysilane, ethyltriethoxysilane, phenyltrimethoxysilane, phenyltriethoxysilane, vinyltrimethoxysilane, vinyltriethoxysilane, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, 3-acryloyloxypropyltrimethoxysilane, perfluoropolyether triethoxysilane or perfluoroethyl triethoxysilane, and is preferably tetraethoxysilane, methyltrimethoxysilane or phenyltriethoxysilane. The silane compound is, in view of crack resistance of the functional layer, preferably at least one member selected from tetraethoxysilane, methyltrimethoxysilane and phenyltriethoxysilane.

As the silane compound, further a bis-silane may be used. The bis-silane is a compound having a structure such that two silicon atoms having a hydrolyzable group are bonded via a bivalent linking group.

The bivalent linking group may be a bivalent hydrocarbon group such as an alkylene group, an alkenylene group or an arylene group. The bivalent hydrocarbon group may have at least one group selected from -O-, -S-, -CO- and -NR$_{S1}$- (wherein R$_{S1}$ is a hydrogen atom or a monovalent hydrocarbon group) between carbon atoms. The bivalent linking group is preferably a C$_{2-8}$ alkylene group, particularly preferably a C$_{2-6}$ alkylene group.

The hydrolyzable group may, for example, be an alkoxy group, an acyloxy group, a ketoxime group, an alkenyloxy group, an amino group, an aminoxy group, an amide group, an isocyanate group or a halogen atom, and is preferably an alkoxy group (particularly a methoxy group or an ethoxy group), an isocyanate group or a halogen atom (particularly a chlorine atom).

To the silicon atom which the bis-silane has, in addition to the hydrolyzable group, a hydrogen atom, a hydroxy group, a monovalent hydrocarbon group or the like may be bonded. The monovalent hydrocarbon group may, for example, be an alkyl group, an alkenyl group or an aryl group. In the bis-silane, the number of the hydrolyzable group bonded to one silicon atom is preferably from 1 to 3, and in view of the reaction rate, preferably 2 or 3, particularly preferably 3.

The silane compound may be used in combination of two or more.

The hydrolyzed condensate of the silane compound is obtained by mixing at least one silane compound, followed by drying by heating in the presence of water and as the case requires, the after-described catalyst (such as an acid catalyst or a basic catalyst).

In a case where the matrix in the present invention contains the silicone resin, the carbon atom content in the functional layer is, in view of the heat resistance of the functional layer, preferably at most 30 at%, particularly preferably at most 20 at%. The carbon atom content in the functional layer may be adjusted by the type and the amount of the silane compound.

The carbon atom content in the functional layer means the content (at%) of carbon atoms to all the atoms constituting the functional layer. The carbon atom content in the functional layer is obtained by an average value by measuring the carbon element number proportion (at%) with respect to optional three points on the surface of the functional layer at an accelerating voltage of 15 keV, and in Example, it is a value obtained by analysis by SEM-EDX ("S-4300", trade name, manufactured by Hitachi Ltd. and "EMAX", trade name, manufactured by HORIBA, Ltd.).

In a case where the matrix in the present invention is the silicone resin, in view of the crack resistance of the functional layer and with a view to making the functional layer thick and improving the shielding properties of the functional layer, the functional layer preferably further contains scaly silica particles.

"Scaly" in the scaly silica particles means a flat shape. The shape of the particles can be confirmed by a transmission electron microscope.

Scaly silica particles comprise, for example, flaky silica primary particles and silica secondary particles formed by a plurality of flaky silica primary particles aligned and overlaid so that their faces are in parallel with each other. The silica secondary particles usually have a laminated structure particle shape. The scaly silica particles may comprise only either one of the silica primary particles and the silica secondary particles.

The thickness of the silica primary particles is preferably from 0.001 to 0.1 μm. When the thickness of the silica primary particles is within the above range, scaly silica secondary particles having a plurality of silica primary particles aligned and overlaid so that their faces are in parallel with each other can be formed. The average aspect ratio of the silica primary particles is preferably at least 2, more preferably at least 5, particularly preferably at least 10.

The thickness of the silica secondary particles is preferably from 0.001 to 3 μm, particularly preferably from 0.005 to 2 μm. The average aspect ratio to the thickness of the silica secondary particles is preferably at least 2, more preferably at least 5, particularly preferably at least 10. The silica secondary particles are preferably present independently of one another without being fused.

The thicknesses of the silica primary particles and the silica secondary particles are measured by an atomic force microscope.

The maximum lengths of the silica primary particles and the silica secondary particles are measured by a transmission electron microscope.

The aspect ratio is the ratio (maximum length/thickness) of the maximum length to the thickness of each particle.

The average aspect ratio is an average of aspect ratios of randomly selected 50 particles.

The average maximum particle size of the scaly silica particles is, in view of excellent crack resistance even when the functional layer is thick, preferably at least 0.05 μm, particularly preferably at least 0.10 μm. The average maximum particle size of the scaly silica particles is, in view of the dispersibility in the matrix, preferably at most 3.00 μm, particularly preferably at most 1.50 μm.

The average maximum particle size of the scaly silica particles is an average of maximum particle sizes of randomly selected 50 particles measured by a transmission electron microscope.

In a case where the functional layer contains the scaly silica particles, the thickness of the functional layer is preferably at least 1 μm, more preferably at least 3 μm, particularly preferably at least 10 μm. The thickness of the functional layer in the above case is preferably at most 300 μm, more preferably at most 150 μm, particularly preferably at most 100 μm.

In a case where the functional layer contains the scaly silica particles, the ratio (thickness of functional layer/average maximum particle size) of the thickness of the functional layer to the average maximum particle size of the scaly silica particles is preferably at least 3, more preferably at least 10, particularly preferably at least 20. The ratio is preferably at most 500, more preferably at most 400, particularly preferably at most 300.

In a case where the functional layer contains the scaly silica particles, the volume fraction of the scaly silica particles in the functional layer is preferably from 5 to 100%, particularly preferably from 10 to 30%, with a view to adjusting the thickness of the functional layer and in view of excellent crack resistance of the functional layer.

The volume fraction of the scaly silica particles in the functional layer is determined as follows.

First, the cross-section of the functional layer in the thickness direction is observed by an SEM "S-4300", trade name, manufactured by Hitachi Ltd.), and with respect to the obtained image, an optional range with a width of 1.5 μm in a direction at right angles to the thickness direction is analyzed by an image analysis software attached to obtain area fractions (percentages (%) based on the total area (thickness × 1.5 μm) of the cross-section analyzed being 100%) of the matrix, the scaly silica particles and the inorganic pigment.

Likewise, with respect to the cross-section SEM image of the functional layer in the thickness direction, two other optional ranges with a width of 1.5 μm are analyzed and the area fractions are obtained.

Finally, the area fractions with respect to totally three ranges with a thickness of 1. 5 μm, are averaged to obtain the volume fraction of the scaly silica particles.

In a case where the functional layer contains the scaly silica particles, the content of the inorganic pigment in the functional layer is preferably at least 1 mass%, more preferably at least 3 mass%, particularly preferably at least 5 mass% to the total mass of the functional layer. The content of the inorganic pigment in the functional layer is preferably at most 50 mass%, more preferably at most 40 mass%, particularly preferably at most 30 mass% to the total mass of the functional layer.

In a case where the functional layer contains the scaly silica particles, it is considered that when the ratio of the average maximum particle size of the scaly silica particles to the thickness of the functional layer is at least 3 and at most 500, the scaly silica particles are likely to be aligned so that the surface directions of the scaly silica particles are in parallel to the direction of the principal plane of the functional layer, and the functional layer is excellent in the crack resistance. Further, it is considered that when the volume fraction of the scaly silica particles in the functional layer is from 5 to 100% and the content of the inorganic pigment in the functional layer is from 1 to 50 mass%, the inorganic pigment is suitably disposed between the scaly silica particles, whereby the dispersibility of the inorganic pigment of the functional layer is excellent, and the above alignment of the scaly silica particles is also more excellent, and the functional layer has further improved crack resistance and design. In addition, it is considered that the inorganic pigment is uniformly dispersed in the functional layer, whereby the present optical layer is excellent in the weather resistance and the present solar cell module is excellent in the power generation efficiency.

As the scaly silica particles, commercial products or processed products thereof may, for example, be used, or products produced may be used. As the scaly silica particles, a powder may be used, or particles dispersed in a dispersion medium may be used. As commercial products of the scaly silica particles, for example, SUNLOVELY (trade name) series manufactured by AGC Si-Tech Co., Ltd. may be mentioned.

In a case where the resin forming the matrix contains the after-described curing agent, the functional layer preferably contains a resin having a crosslinked structure formed by reaction of the crosslinkable groups which the resin has and the curing agent, in view of the hardness and the durability of the functional layer.

Further, in a case where the resin forming the matrix contains the after-described curing agent, the present optical layer may have a crosslinked structure formed by reaction of at least two selected from the group consisting of the crosslinkable groups which the resin contained in the functional layer has, the curing agent, and the reactive groups which a layer other than the functional layer has. In such a case, the reactive groups which the layer other than the functional layer has have a function as crosslinkable groups.

The reactive group which the layer other than the functional layer has may, for example, be a silanol group in a case where the layer other than the functional layer is a substrate layer comprising a glass plate, or a hydrolyzable silyl group in case where the layer other than the functional layer is a layer surface-treated with e.g. a silane coupling agent.

For example, in case where the functional layer is formed on a substrate layer comprising a glass plate from a resin containing a curing agent having at least one member selected from a hydrolyzable silyl group and a silanol group, the hydrolyzable silyl group or the like in the curing agent (specifically, a silanol group formed by hydrolysis) and the silanol group present on the surface of the glass plate are reacted to form a crosslinked structure. Accordingly, the adhesion of the functional layer to the substrate layer is more excellent. Further, in such a case, when the substrate layer is a layer comprising a glass plate surface-treated with e.g. a silane coupling agent, the silanol group present on the surface of the glass plate, the hydrolyzable silyl group or the like which the silane coupling agent has, and the hydrolyzable silyl group or the like in the curing agent, are reacted to form a crosslinked structure. Accordingly, the adhesion between the substrate layer and the functional layer improves, and the present optical layer is excellent in the durability.

In a case where the matrix in the present invention is a sintered product obtained by sintering a glass frit composition, the glass frit composition comprises a glass powder obtained by pulverizing glass and as the case requires, contains at least one component G described hereinafter.

The 50% particle diameter (D50) of the glass powder is preferably from 1.0 to 10.0 $\mu$m, preferably from 3.0 to 8.0 $\mu$m.

The 90% particle diameter (D90) of the glass powder is preferably from 5.0 to 30.0 $\mu$m, preferably from 8.0 to 16.0 $\mu$m. The 50% particle diameter (D50) and the 90% particle diameter (D90) are particle diameters corresponding to the cumulative amount 50% and 90% in a particle diameter cumulative distribution (volume basis). The 50% particle diameter (D50) and the 90% particle diameter (D90) are measured by a laser diffraction particle size distribution measuring apparatus.

The glass powder preferably contains at least one element selected from Li, B, Na, Mg, Al, Si, K, Ca, Ti, Mn, Cu, Zn, Sr, Ag, Ba, Bi, Fe, Co, Ce, Nb, Ta, Sb, Cs, P, Zr, La and Sn, more preferably contains at least one element selected from Ba, B, Al, Cu, Zn, Bi, Fe and Ce, particularly preferably contains at least one element selected from Ba, B and Zn.

The composition and the contents of the respective elements of the glass powder are properly adjusted so that the glass powder has a suitable softening point.

The amount of the glass powder contained in the glass frit composition is properly adjusted together with the amount of the after-described thermal expansion coefficient-adjusting agent so that the thermal expansion coefficient of a sintered product obtained by sintering the glass frit composition is suitable.

The softening point of the glass powder is, in a case where the present optical layer has a substrate layer comprising a glass plate, and a functional layer containing a glass frit sintered product is directly laminated on at least one surface of the substrate layer, required to be less than the softening point of the substrate layer, so as to prevent deformation by softening of the substrate layer at the time of sintering. Particularly in a case where soda lime silicate glass is used as the substrate layer, the softening point of the glass powder is preferably from 450 to 700°C, particularly preferably from 500 to 600°C.

The glass powder is not particularly limited and for example, with a view to reducing the environmental burden, preferably a glass powder comprising glass containing no lead, particularly preferably a glass powder comprising barium zinc borate glass. The barium zinc borate glass is, for example, as represented by mass% based on oxides of metal elements contained in the glass, preferably glass containing from 20 to 50% of BaO, from 10 to 35% of $B_2O_3$ and from

5 to 25% of ZnO. Particularly in a case where the present optical layer has a substrate layer comprising a glass plate and has a functional layer containing a sintered product formed from a glass frit composition directly laminated on at least one surface of the substrate layer, in view of hardness of the present optical layer, the glass powder preferably contains, as represented by mass% based on oxides of metal elements contained in the glass, from 28 to 43% of BaO, from 13 to 28% of $B_2O_3$ and from 10 to 20% of ZnO.

The component G may, for example, be a thermal expansion coefficient-adjusting agent, a release agent or a reducing agent. The sintered product is produced by using a binder or an organic solvent not contained in the glass frit sintered product, in addition to the component G.

The binder is to fix the glass powder in the glass frit composition before sintering the glass frit composition and is removed by heating when the glass frit composition is sintered. Accordingly, the binder is not contained in the glass frit sintered product.

In a case where the glass frit composition contains the binder and the organic solvent, the glass frit composition is in a paste form and can thereby be easily applied. The binder is preferably an organic binder, such as ethyl cellulose, a polypropylene carbonate acrylic resin, a styrene resin, a phenol resin or a butyral resin, and is preferably ethyl cellulose in view of printing properties.

The organic solvent is to dissolve the binder and is selected depending upon the type of the binder. The organic solvent is removed by heating at the time of drying by heating and sintering the glass frit composition. Accordingly, the glass frit sintered product does not contain the organic solvent.

The organic solvent may, for example, be 2,2,4-trimethylpentane-1,3-diol monoisobutyrate, ethylene glycol mono-2-ethylhexyl ether, α-terpineol, butyl carbitol acetate or a phthalate, and in view of printing properties, preferably 2,2,4-trimethylpentane-1,3-diol monoisobutyrate or ethylene glycol mono-2-ethylhexyl ether.

The thermal expansion coefficient-adjusting agent is to adjust the thermal expansion coefficient of the functional layer at least containing the glass frit composition and the inorganic pigment. The thermal expansion coefficient of the functional layer and the thermal expansion coefficient of the substrate (e.g. glass plate) do not fit each other, when the glass frit composition is sintered to obtain a sintered product, the functional layer or the substrate may be warped or have cracking. Accordingly, in order to prevent warpage or cracking at the time of forming the functional layer, for example, in a case where the functional layer is formed on the substrate layer, it is preferred to adjust the thermal expansion coefficient of the functional layer to be close to the thermal expansion coefficient of the substrate layer by the thermal expansion coefficient-adjusting agent.

The thermal expansion coefficient-adjusting agent is preferably at least one member selected from cordierite, aluminum titanate, alumina, mullite, silica, zinc oxide ceramic, β-eucryptite, β-spodumene, zirconium phosphate ceramic and β-quartz solid solution, more preferably a powder thereof.

In a case where the thermal expansion coefficient-adjusting agent is a powder, the 50% particle diameter (D50) of the thermal expansion coefficient-adjusting agent is preferably from 1.0 to 10.0 μm, preferably from 1.5 to 5.0 μm. The 90% particle diameter (D90) of the thermal expansion coefficient-adjusting agent is preferably from 1.0 to 10.0 μm, preferably from 3.0 to 8.0 μm. The type and the amount of the thermal expansion coefficient-adjusting agent are properly selected so that the glass frit composition has a desired thermal expansion coefficient.

For example, in a case where the soda lime silicate glass is used for the substrate layer, preferred is a combination of the barium zinc borate glass powder as the glass frit composition, cordierite as the thermal expansion coefficient-adjusting agent and Co-Al composite oxide as the inorganic pigment.

In the matrix, the contents of the glass frit sintered product, the thermal expansion coefficient-adjusting agent and the inorganic pigment are respectively preferably from 50 to 85 mass%, from 10 to 30 mass% and from 1 to 20 mass% in this order to the total mass of the matrix, particularly preferably from 60 to 80 mass%, from 15 to 25 mass% and from 5 to 10 mass%.

In the above case, the adhesion between the substrate layer and the functional layer is favorable, and the present optical layer is excellent in the strength. Further, since the inorganic pigment is favorably dispersed in the matrix, the present solar cell module is excellent in the design and the power generation efficiency.

The functional layer in the present invention according to an embodiment is a layer formed of a functional layer-forming composition (hereinafter referred to as composition (1)) at least containing the polymer (particularly the fluorinated polymer) and the inorganic pigment. The composition (1) may contain two or more types of polymer. Further, the composition (1) may contain two or more types of inorganic pigment.

As the polymer, a polymer contained in the resin constituting the matrix as described above may be mentioned, and a fluorinated polymer is preferred.

The inorganic pigment in the composition (1) is the same as the above-described inorganic pigment in the present invention, and its details are omitted.

In a case where the composition (1) is a functional layer-forming composition (hereinafter referred to as composition (1F)) containing a fluorinated polymer as the polymer, the fluorinated polymer in the composition (1F) preferably has the following physical properties.

In a case where the fluorinated polymer is a fluorinated polymer having carboxy groups, the acid value of the fluorinated polymer is, in view of the strength of the functional layer, preferably from 1 to 200 mgKOH/g, preferably from 1 to 150 mgKOH/g, more preferably from 3 to 100 mgKOH/g, particularly preferably from 5 to 50 mgKOH/g.

In a case where the fluorinated polymer is a fluorinated polymer having hydroxy groups, the hydroxy value of the fluorinated polymer is, in view of the strength of the functional layer, preferably from 1 to 200 mgKOH/g, preferably from 1 to 150 mgKOH/g, more preferably from 3 to 100 mgKOH/g, particularly preferably from 10 to 60 mgKOH/g.

The fluorinated polymer may have only one of the acid value and the hydroxy value, or may have both.

The fluorine atom content in the fluorinated polymer is, in view of dispersibility of the inorganic pigment in the matrix, preferably at most 70 mass%, more preferably at most 50 mass%, particularly preferably at most 30 mass%, most preferably at most 28 mass%. Further, the fluorine atom content in the fluorinated polymer is preferably at least 10 mass%, particularly preferably at least 15 mass%, in view of the weather resistance of the functional layer.

Particularly when the fluorine atom content in the fluorinated polymer is preferably from 15 to 30 mass%, particularly preferably from 15 to 28 mass%, the inorganic pigment is favorably dispersed in the functional layer, and the present optical layer has a high near infrared transmittance and a high visible transmittance, and accordingly the present solar cell module is excellent in the design and the power generation efficiency.

The fluorine atom content in the fluorinated polymer means a proportion (mass%) of fluorine atoms to all the atoms constituting the fluorinated polymer. The fluorine atom content is obtained by analyzing the fluorinated polymer by nuclear magnetic resonance (NMR) spectroscopy.

Except for the above, the fluorinated polymer is the same as the fluorinated polymer in the matrix as described above, and its details are omitted.

The content of the fluorinated polymer in the composition (1F) is, in view of dispersibility of the inorganic pigment in the composition (1 F), preferably from 10 to 90 mass%, particularly preferably from 20 to 40 mass% to the total mass of the composition (1F).

The content of the fluorinated polymer in the solid content of the composition (1F) is, in view of the dispersibility of the inorganic pigment in the composition (1F), preferably from 10 to 90 mass%, particularly preferably from 40 to 70 mass% to the total mass of the solid content in the composition (1F).

The content of the inorganic pigment in the solid content in the composition (1F) is, in view of the dispersibility of the inorganic pigment in the composition (1F), preferably from 5 to 80 mass%, particularly preferably from 20 to 50 mass% to the total mass of the solid content in the composition (1F).

The composition (1) may contain, in addition to the inorganic pigment and the polymer, at least one component X which is a component other than the inorganic pigment and the polymer. Such a component X may, for example, be a curing agent, a catalyst, a filler (e.g. an organic filler such as resin beads), an organic pigment (such as carbon black (black), copper phthalocyanine (blue, green) or perylene (red)), an organic photostabilizer, an organic ultraviolet absorber, an inorganic ultraviolet absorber, a delustering agent, a dispersing agent, an anti-foaming agent, a leveling agent, a surface modifier, a degassing agent, a bulking agent, a thermal stabilizer, a thickener, a surfactant, an antistatic agent, an anti-corrosive agent, a silane coupling agent, a stain-proofing agent, a low contamination treatment agent, a plasticizer or an adhesive.

However, in view of the weather resistance of the functional layer, it is preferred that no organic pigment is contained, or if contained, its content is less than 1 mass% in the entire pigment.

The composition (1) may contain, as the case requires, a component which is not contained in the functional layer. Such a component may, for example, be a liquid medium. A liquid medium such as water or an organic solvent is a component removed e.g. by evaporation at the time of forming the matrix, and in a case where the functional layer is formed by means of e.g. coating, it is contained in the composition (1).

The solid content concentration in the composition (1F) is preferably adjusted to preferably from 10 to 90 mass%, more preferably from 40 to 70 mass% to the total mass of the composition (1F) by the liquid medium.

In a case where the composition (1) contains a curable resin or a crosslinkable polymer, it particularly preferably contains, among the components X, a curing agent which constitutes a crosslinked structure in the above-described functional layer.

In a case where the polymer in the composition (1) has crosslinkable groups, the functional layer can be cured by crosslinking the crosslinkable groups of the polymer and the curing agent. In such a case, the functional layer has a crosslinked structure of the polymer and the curing agent.

Further, in a case where the curing agent in the composition (1) contains at least one member selected from the hydrolyzable silyl group and the silanol group, it is considered that the curing agent, the glass plate containing silicon oxide as the substrate layer and as the case requires, the polymer, are reacted to form a functional layer having a crosslinked structure of the curing agent and the glass plate and as the case requires, the polymer.

In a case where the composition (1) contains the curing agent, the content of the curing agent is preferably at least 5 parts by mass and at most 200 parts by mass, particularly preferably at least 10 parts by mass and at most 150 parts by mass, per 100 parts by mass of the polymer in the composition (1).

In a case where the polymer has hydroxy groups, the curing agent is preferably a compound having at least 2 isocyanate groups or blocked isocyanate groups in one molecule.

In a case where the polymer is a curing agent having carboxy groups, the curing agent is preferably a compound having at least 2 epoxy groups, carbodiimide groups, oxazoline groups or β-hydroxyalkylamide groups in one molecule.

In a case where the polymer has both hydroxy groups and carboxy groups, as the curing agent, it is preferred to use a compound having at least 2 isocyanate groups or blocked isocyanate groups in one molecule and a compound having at least 2 epoxy groups, carbodiimide groups, oxazoline groups or β-hydroxyalkylamide groups in one molecule in combination.

Further, in a case where the present optical layer has a substrate layer comprising a glass plate, the curing agent is preferably a curing agent having at least one member selected from a hydrolyzable silyl group and a silanol group, whereby the adhesion between the functional layer and the substrate layer will more improve.

The composition (1) preferably contains a dispersing agent in view of the dispersibility of the inorganic pigment. The dispersing agent may, for example, be a fatty amide, an ester salt of an acid polyimide, an acrylic resin, an oxidized polyolefin or a polymer compatible with the inorganic pigment. As the dispersing agent, commercial products may be used, such as "DISPARLON" series (trade name by Kusumoto Chemicals, Ltd.) and "DISPERBYK" series (trade name by BYK Japan KK).

The functional layer in the present invention according to an embodiment is a layer formed of a functional layer-forming composition (hereinafter referred to as composition (2)) at least containing a silane compound, scaly silica particles and an inorganic pigment. The composition (2) may contain at least two types of silane compound and scaly silica particles. Further, the composition (2) may contain at least two types of inorganic pigment.

In the composition (2), the silane compound, the scaly silica particles, the inorganic pigment and their contents are the same as the silane compound and the scaly silica particles described for the silicone resin in the present invention and the inorganic pigment in the present invention, and their details are omitted.

The composition (2) may contain a component other than the silane compound, the scaly silica particles and the inorganic pigment, and as such components, the above component X may be mentioned.

The composition (2) preferably contains, among the components X, a catalyst which promotes hydrolysis of the silane compound. Such a catalyst may, for example, be an acid catalyst or an alkali catalyst, and is preferably an acid catalyst, in view of long term stability after hydrolytic condensation of the silane compound.

The acid catalyst may, for example, be an inorganic acid (such as nitric acid, sulfuric acid or hydrochloric acid) or an organic acid (such as formic acid, oxalic acid, monochloroacetic acid, dichloroacetic acid or trichloroacetic acid).

The alkali catalyst may, for example, be ammonia, sodium hydroxide, potassium hydroxide or electrolytically reduced water having a pH of from 10.5 to 12.

It is preferred that the composition (2) at least contains a medium (particularly a liquid medium) and that the silane compound, the scaly silica particles and the inorganic pigment are dispersed in the liquid medium. The liquid medium may be water, an organic solvent or a mixture thereof, and at least water is preferably contained.

The total content of the silane compound and the scaly silica particles in the composition (2) is, in view of the dispersibility in the composition (2), preferably from 1 to 99 mass%, particularly preferably from 30 to 90 mass% to the total mass of the composition (2).

The content of the inorganic pigment in the composition (2) is, in view of the dispersibility of the inorganic pigment in the composition (2), preferably from 0.01 to 50 mass%, particularly preferably from 1 to 30 mass% to the total mass of the composition (2).

The functional layer in the present invention according to an embodiment is a layer formed of a functional layer-forming composition (hereinafter referred to as composition (3)) at least containing a glass frit composition and an inorganic pigment.

The glass frit composition and the inorganic pigment in the composition (3) are the same as the glass frit composition in the present invention and the inorganic pigment in the present invention, and their details are omitted.

The composition (3) may contain a component other than the glass frit composition and the inorganic pigment, and as such a component, the above-described component G may be mentioned, and the composition (3) preferably contains, among the components G, a thermal expansion coefficient-adjusting agent.

The composition (3) may contain a binder or an inorganic solvent, which is a component not contained in the sintered product, as mentioned above. In such a case, the composition (3) is in a paste form, and application of the composition (3) and formation of the functional layer are easy. Further, the inorganic pigment is suitably dispersed in the composition (3), and the present solar cell module is excellent in the design.

In a case where the functional layer is a layer formed of the composition (1), the functional layer may be produced by forming the composition (1) into a layer, or may be produced by applying the composition (1) to a layer other than the functional layer which the present optical layer has (for example, a substrate layer), followed by drying by heating. The functional layer is, in view of the dispersibility of the inorganic pigment in the matrix, preferably produced by applying the composition (1) to a layer other than the functional layer which the present optical layer has. That is, the composition (1) is preferably a coating material containing the fluorinated polymer.

In a case where the present solar cell module is to be produced, it is preferred that the coating material is applied to a substrate layer to produce an optical layer, which is contact-bonded to the after-described encapsulant layer. Accordingly, the functional layer in the optical layer is preferably a layer formed by applying the coating material, also in that the functional layer will not protrude at the edges at the time of contact-bonding to the encapsulant layer, as compared with a case where the functional layer is a film.

In a case where the composition (1) is formed to produce the functional layer, the forming method may, for example, be extrusion, injection molding or blow molding. In such a case, the composition (1) may be formed into a layer and laminated on a layer other than the functional layer which the present optical layer has.

In a case where the composition (1) is a coating material (such as an aqueous coating material or a solvent-based coating material) containing a liquid medium and having the solid content of the composition (1) dispersed or dissolved in the medium, the coating method may, for example, be specifically spray coating method, squeeze coating method, flow coating method, bar coating method, spin coating method, dip coating method, screen printing method, gravure coating method, die coating method, ink jet method, curtain coating method or a method using a brush or a spatula. The composition (1) is preferably a solvent-based coating material in which the fluorinated polymer is dissolved or dispersed in a solvent, whereby a functional layer with favorable dispersibility in the matrix, can be formed.

In a case where the composition (1) is a coating material (e.g. a powder coating material) containing no liquid medium, the coating method may, for example, be specifically electrostatic coating method, electrostatic spraying method, electrostatic dipping method, atomizing method, fluidized-bed coating method, spray coating method, spraying method, thermal spraying method or plasma spray coating method.

In a case where the composition (1) is applied to a layer other than the functional layer which the present optical layer has to produce the functional layer, the coating layer obtained by applying the composition (1) is preferably dried by heating, after applying. The temperature for drying by heating the coating layer is usually from 0°C to 300°C, and the time for drying by heating is usually from 1 minute to 2 weeks.

In a case where the functional layer is a layer formed of the composition (1), the present optical layer is preferably a layer comprising a substrate layer and a functional layer directly laminated on at least one surface of the substrate layer, wherein the substrate layer comprises a surface-treated glass plate. That is, in the above case, it is preferred that at least one surface of the glass plate is surface-treated by a known surface treatment method to obtain a substrate layer, and on at least one surface of the obtained substrate layer, the composition (1) is directly applied to form a functional layer thereby to obtain the present optical layer. Particularly in a case where the surface treatment is e.g. application of a silane coupling agent, a -Si-OH group which the glass plate has in the substrate layer and a -Si-OH group which the silane coupling agent has interact with each other, and the surface-treated substrate layer and the functional layer are closely contacted with each other, whereby the present optical layer is excellent in durability.

In a case where the functional layer is a layer formed of the composition (2), the functional layer is preferably produced by applying the composition (2) to a layer other than the functional layer which the present optical layer has (for example, a substrate layer), followed by drying by heating. In such a case, the coating method may be the coating method as described for the composition (1), and is preferably spray coating method.

In a case where the composition (2) is applied by spray coating method, it can be applied, for example, by electrifying the composition (2) by using a known electrostatic coating apparatus having a known electrostatic coating gun provided with a rotary atomizing head, and spraying it on a principal plane of the substrate layer (preferably a substrate layer comprising a glass plate). After applying, it is preferred to dry by heating a coating layer obtained by applying the composition (2) for curing thereby to form the functional layer. By drying the coating layer by heating, a hydrolyzed condensate of a silane compound e.g. having a siloxane bond is formed. The temperature for drying by heating the coating layer is usually from 30°C to 700°C, and the time for drying by heating is usually from 1 minute to 30 minutes.

In a case where the functional layer is a layer formed of the composition (2), the present optical layer preferably has a glass plate and a functional layer directly laminated on at least one surface of the glass plate. That is, in the above case, the present optical layer is preferably obtained by directly applying the composition (2) on at least one surface of the substrate layer comprising a glass plate to form the functional layer. In such a case, it is considered that a -Si-OH group which the glass plate has and a -Si-OH group which the silane compound has interact with each other and a part thereof form a Si-O-Si bond, and accordingly the adhesion between the substrate layer and the functional layer is particularly excellent, and the present optical layer is excellent in durability.

In a case where the functional layer is a layer formed of the composition (3), the functional layer may be produced by applying the composition (3) on a layer other than the functional layer which the present optical layer has (for example, a substrate layer), followed by drying by heating and sintering, or it may be produced by applying the composition (3) on e.g. a resin film, followed by drying by heating, removing the resin film or the like, and sintering the obtained heat-dried product.

The coating method may be the coating method described for the composition (1), and is preferably curtain coating method, screen printing method or ink jet method.

In a case where the composition (3) contains a binder and an organic solvent, the organic solvent is removed by first drying by heating, the binder is removed by second drying by heating, and sintering occurs in third drying by heating, whereby the glass powder is bonded which the composition (3) contains.

The temperature for first drying by heating is preferably from 100 to 150°C. The temperature for second drying by heating is preferably from 300 to 450°C, particularly preferably from 350 to 400°C. The temperature for third drying by heating is preferably from 450 to 700°C, particularly preferably from 550 to 650°C. The temperature for drying by heating and sintering may be properly adjusted e.g. by the type of the substrate layer, the softening point of the glass frit composition, or the thermal expansion coefficient.

The substrate layer is made from a material which does not lower the near infrared transmittance of the present optical layer. The substrate layer specifically has, an average near infrared transmittance of at least 10%, preferably at least 100%, which is a value calculated by simply averaging near infrared transmittances at 5 nm intervals in a near infrared region at a wavelength of from 780 to 1,500 nm.

The substrate layer is made of an organic material or an inorganic material, and in view of the near infrared transmittance, it is preferably a glass plate or a resin formed product, particularly preferably a glass plate.

The glass plate may be made of e.g. soda lime silicate glass, quartz glass, crystal glass, alkali-free glass, aluminosilicate glass, borosilicate glass or barium borosilicate glass, and in view of high near infrared transmittance, preferably made of soda lime silicate glass.

The soda lime silicate glass may, for example, be specifically glass having a composition comprising, as calculated as oxides, from 60 to 75 mass% of $SiO_2$, from 0 to 3 mass% of $Al_2O_3$, more than 0 and at most 15 mass% of $CaO$, from 0 to 12 mass% of $MgO$ and from 5 to 20 mass% of $Na_2O$. Here, $SiO_2$ is the main component of the soda lime silicate glass.

Soda lime silicate glass may further contain, in addition to the above components, at least one material selected from the group consisting of $K_2O$, $TiO_2$, $ZrO_2$ and $LiO_2$.

Further, the soda lime silicate glass may further contain a clarifying agent (such as $SO_3$, $SnO_2$ or $Sb_2O_3$).

The glass plate may be a tempered glass plate having tempering treatment applied thereto. A tempered glass plate is preferred since it is hardly broken as compared with a glass plate having no tempering treatment applied thereto. As a tempered glass plate, for example, a glass plate having a front layer having residual compressive stress, a rear layer having residual compressive stress, and an interlayer having residual tensile stress formed between the front layer and the rear layer, is used.

The tempering treatment may, for example, be specifically chemical tempering treatment carried out e.g. by known ion exchange method or physical tempering treatment carried out e.g. by known air-cooling tempering method. A chemically tempered glass plate has sufficient strength even if the glass plate has a small plate thickness, since the front layer or the rear layer has large residual compressive stress.

The resin formed product is a resin formed into e.g. a plate or a film. The resin may, for example, be a fluororesin, an alkyd resin, an amino alkyd resin, a polyester resin, an epoxy resin, a urethane resin, an epoxy polyester resin, a vinyl acetate resin, a (meth)acrylic resin, a vinyl chloride resin, a phenol resin, a modified polyester resin, an acrylic silicone resin or a silicone resin. The resin formed product is preferably a fluororesin film in view of the weather resistance and the near infrared transmittance.

The fluororesin may be a resin containing polytetrafluoroethylene, polychlorotrifluoroethylene, a tetrafluoroethylene/hexafluoropropylene copolymer, polyvinylidene fluoride, a fluoroolefin/perfluoro(alkyl vinyl ether) copolymer or an ethylene/tetrafluoroethylene copolymer. The fluororesin is, in view of processability and near infrared transmittance, preferably a resin containing polyvinylidene fluoride or an ethylene/tetrafluoroethylene copolymer.

As the fluororesin, commercial products may be used, such as "Fluon" series (trade name by AGC Inc.) and "Kynar" series (trade name by Arkema).

The average thickness of the substrate layer is optionally set depending upon e.g. the designed wind pressure of a building. The average thickness of the substrate layer is preferably at least 1 mm, more preferably at least 2 mm, particularly preferably at least 3 mm. The average thickness of the substrate layer is preferably at most 30 mm, more preferably at most 20 mm, particularly preferably at most 15 mm. When the average thickness is at least 1 mm, the substrate has high durability, and the present optical layer is hardly broken. When the average thickness is at most 30 mm, the present optical layer is light in weight, and the present solar cell module is more suitably used for the wall surface or windows of a building.

The average thickness of the substrate layer is an arithmetic mean value of the thicknesses measured by a thickness meter.

The substrate layer may be a layer obtained by surface-treating the material, in view of the adhesion to a layer other than the substrate layer. The surface treatment method may be a known method, such as activation treatment (plasma method, deposition method, acid treatment or base treatment), chemical conversion, polishing of the material surface, sander treatment, sealing treatment, blasting treatment or primer treatment.

The substrate layer is particularly preferably a layer comprising a surface-treated glass plate. In such a case, a surface treatment method is preferably primer treatment (particularly application of a primer agent).

The primer agent may, for example, be a silane coupling agent (particularly an alkoxysilane or the like), a titanium coupling agent, an epoxy resin, a (meth)acrylic resin or a polyester resin, and in a case where the material to be surface-treated is a glass plate, preferably a silane coupling agent or a titanium coupling agent.

The silane coupling agent is, in a case where the functional layer is a layer formed of the composition (1), in view of the adhesion to the substrate layer and durability, preferably a compound having from 3 to 4 alkoxy groups or isocyanate groups as hydrolyzable groups and from 0 to 1 non-hydrolyzable group bonded to a silicon atom. The non-hydrolyzable group is preferably an alkyl group which may have a functional group, and the functional may, for example, be an amino group, an isocyanate group, a hydroxy group or an epoxy group.

The silane coupling agent may, for example, be specifically 3-isocyanatopropyltrialkoxysilane, 3-aminopropyltrialkoxysilane, methyltriisocyanatosilane or tetraisocyanatosilane, and as commercial products, ORGATIX SI-310, SI-400, manufactured by Matsumoto Fine Chemical Co., Ltd. may, for example, be used.

The titanium coupling agent is, in a case where the functional layer is a layer formed of the composition (1), in view of the adhesion to the substrate layer and the durability, preferably an alkoxy titanium ester, titanium chelate or titanium acylate, more preferably an alkoxy titanium ester derivative containing a titanium oligomer. The titanium coupling agent is particularly preferably a compound represented by $(RO)_x(TiO)_{y/2}$ (wherein X and Y are each independently a positive integer). As commercial products, ORGATIX PC-620 and PC-601 manufactured by Matsumoto Fine Chemical Co., Ltd. may, for example, be used.

When a glass plate having a silane coupling agent or a titanium coupling agent applied thereto is used as the substrate layer, even when the composition (1) (particularly the composition (1) containing a fluororesin) is directly applied on at least one surface of the substrate layer, the adhesion between the substrate layer and the functional layer is excellent. Further, the adhesion between the substrate layer and the functional layer in a case where the present optical layer is dipped in water improves, and such is suitable for a solar cell module which is used outdoor.

The present optical layer has been described with reference to Fig. 1. The present optical layer should only have a functional layer, as described above, and may not have the substrate layer. The present optical layer preferably has the substrate layer in view of the strength of the present optical layer.

The present optical layer may consist solely of the functional layer. Further, the present optical layer may have a layer other than the functional layer within a range not to impair the effects of the present invention. The layer other than the functional layer may, for example, be a substrate layer, an adhesive layer or an air layer. Further, the present optical layer may have a plurality of functional layers, or may have a plurality of layers other than the functional layer. The present optical layer should only have the functional layer, and the order of disposition of layers which the present optical layer has can be suitably selected.

The adhesive layer may, for example, be a layer which makes two or more layers which the present optical layer has be attached to each other.

The air layer may, for example, be a layer, in a case where the present optical layer is a bag-form film, which maintains the present optical layer in a state expanding in a cushion form. On that occasion, solar cells may be installed in the interior of the present optical layer.

The present optical layer is disposed on the side of plane of incidence of sunlight of solar cells. Usually, solar cells are not used alone, but a plurality of solar cells are aligned next to one another and electrically connected in series or in parallel. Accordingly, typically, the present optical layer is disposed as a continuous plane relative to such a plurality of solar cells, and is present on the side of plane of incidence of sunlight of such solar cells.

The present optical layer does not typically contain an encapsulant layer to encapsulate solar cells. The present optical layer is preferably laminated on the encapsulant layer (on the side of plane of incidence of sunlight of the encapsulant layer), in view of more excellent effects of the present invention.

The present optical layer may have irregularities on the surface on the air side so as not to impair the effects of the present invention. An embodiment of the present optical layer having irregularities on the surface on the air side, may, for example, be an embodiment such that the present optical layer has the functional layer as the outermost layer on the air side, and the functional layer contains a delustering agent, or an embodiment such that the present optical layer has the substrate layer as the outermost layer on the air side, and the substrate layer is properly surface-treated e.g. by polishing.

Fig. 2 is a cross-sectional view illustrating an embodiment of the present solar cell module 20 (hereinafter sometimes referred to as embodiment 1). The embodiment 1 is preferred in that since the substrate layer is disposed as the outermost layer, the design can be imparted to the present solar cell module while the texture of the substrate is made good use of.

As shown in Fig. 2, the solar cell module 20 comprises an optical layer 10 comprising a substrate layer 110 and a functional layer 120, a plurality of solar cells 14, an encapsulant layer 16 and a rear protective layer 18. The optical layer 10 is laminated on the encapsulant layer 16, and is disposed on the side of plane of incidence of sunlight 40 of the solar cells 14. All the plurality of solar cells 14 are encapsulated in the encapsulant layer 16.

The optical layer 10 is used as an optical layer for a solar cell module and imparts the design and the weather resistance to the solar cell module 20.

In the embodiment 1, the functional layer is preferably a functional layer in which the matrix is at least one member selected from a fluororesin, a silicone resin and a sintered product obtained by sintering a glass frit composition, and in view of the adhesion to the encapsulant layer, preferred is a fluororesin or a silicone resin.

In the embodiment 1, the substrate layer is preferably a glass plate in view of durability of the optical layer.

Each of the solar cells 14 has a first light-receiving surface 14A and a second light-receiving surface 14B facing the first light-receiving surface 14A. Each solar cell 14 has a function to convert light energy received by the first light-receiving surface 14A and the second light-receiving surface 14B to electric energy. Each solar cell may have this function only on the first light-receiving surface or on both the first light-receiving surface and the second light-receiving surface.

The solar cells in the present invention are preferably made of a material having spectral sensitivity in a near infrared region. Specifically, they may be silicon-based solar cells composed of monocrystalline silicon, polycrystalline silicon or the like, or compound-based solar cells composed of e.g. GaAs, CIS, CIGS, CdTe, InP, $Zn_3P_2$ or $Cu_2S$. The solar cells are particularly preferably CIS solar cells or CIGS solar cells, which require no wiring and thereby achieves more excellent design of the present solar cell module and can be suitably used as an outer wall material, and which is more excellent in the power generation in the near infrared region. Further, in a case where the solar cells have wiring, in view of the design of the present solar cell module, the wiring is preferably colored, particularly preferably colored black.

Fig. 3 is a graph illustrating a sunlight spectrum (solar energy) on the ground and a spectral sensitivity curve of a monocrystalline silicon solar cell.

As shown in Fig. 3, the monocrystalline silicon-based solar cell has high spectral sensitivity also in a long wavelength range at a wavelength of higher than 780 nm. That is, it means that a solar cell module having both the design and the power generation efficiency can be obtained by using the present optical layer showing a high transmittance in a long wavelength region.

The encapsulant layer 16 has a function to encapsulate the solar cells 14.

The material constituting the encapsulant layer in the present invention may, for example, be specifically an ethylene/vinyl acetate resin, an olefin resin, a polyvinyl butyral resin, an ionomer resin or a silicone resin. The encapsulant layer typically preferably contains no inorganic pigment or the like in the present invention or if contains, in a proportion of less than 1 mass% to the resin, since it is required to have adhesion to the solar cells and a protective effect.

The rear protective layer 18 is disposed on an opposite side of the solar cells from the side of plane of incidence of sunlight in the solar cell module.

The rear protective layer in the present invention is preferably a layer which improves the strength and the light resistance of the solar cell module. As specific examples of the material constituting the rear protective layer, the same materials as the materials constituting the substrate layer may be mentioned.

The rear protective layer is preferably black in view of the design of the present solar cell module. Specifically, the rear protective layer is preferably a black glass plate or a glass plate having black coating applied thereto.

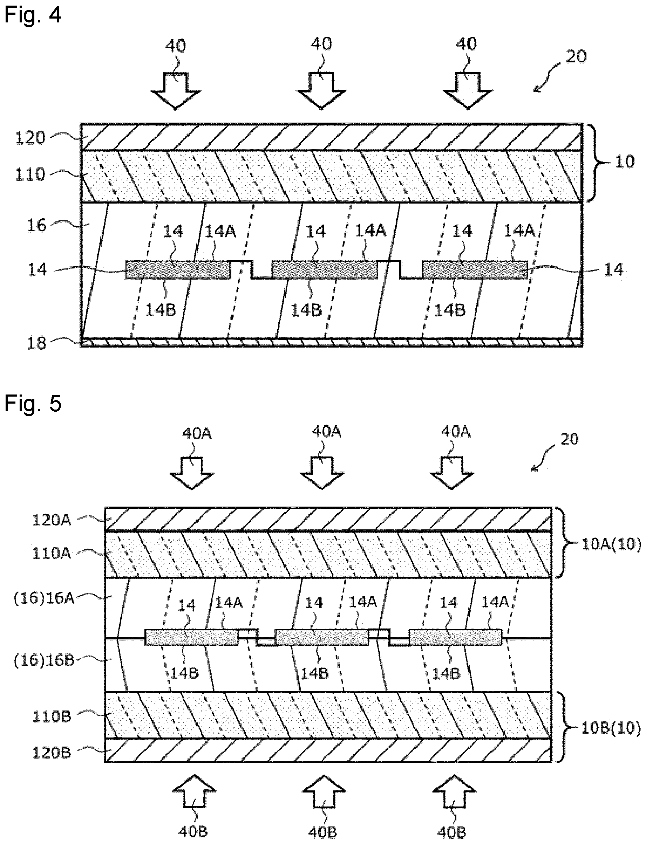

Fig. 4 is a cross-sectional view illustrating an embodiment of the present solar cell module 20 (hereinafter sometimes referred to as embodiment 2). The embodiment 2 is preferred in that since the functional layer is disposed as the outermost layer, the texture of the functional layer can be made good use of,.

As shown in Fig. 4, the solar cell module 20 comprises an optical layer 10 comprising a substrate layer 110 and a functional layer 120, a plurality of solar cells 14, an encapsulant layer 16, and a rear protective layer 18. The optical layer 10 is laminated on the encapsulant layer 16, and is disposed on the side of plane of incidence of sunlight 40 of the solar cells 14. The plurality of solar cells 14 are all encapsulated in an encapsulant layer 16.

In the embodiment 2, the functional layer is preferably a functional layer in which the matrix is at least one member selected from the group consisting of a fluororesin, a silicone resin, and a sintered product obtained by sintering a glass frit composition.

Details of the respective layers in the embodiment 2 are the same as in the embodiment 1, and their description is omitted.

Fig. 5 is a cross-sectional view illustrating an embodiment of the present solar cell module 20 (hereinafter sometimes referred to as embodiment 3). The embodiment 3 is preferred in that the present solar cell module is suitably used in a case where sunlight enters from both sides, for example, for a fence.

As shown in Fig. 5, the solar cell module 20 comprises a first optical layer 10A, a plurality of solar cells 14, a first encapsulant layer 16A, a second encapsulant layer 16B and a second optical layer 10B. In the following description, the first optical layer 10A and the second optical layer 10B may sometimes be generally referred to as an optical layer 10. Further, the first encapsulant layer 16A and the second encapsulant layer 16B may sometimes be generally referred to as an encapsulant layer 16. The optical layer 10 is laminated on the encapsulant layer 16, and is disposed on the side of plane of incidence of sunlight 40A and 40B of the solar cells 14. All the plurality of solar cells 14 are encapsulated in the encapsulant layers 16A and 16B. The first optical layer 10A comprises a substrate layer 110A and a functional layer 120A disposed on the substrate layer 110A.

The first optical layer 10A is disposed on the side of a first light-receiving surface 14A of the solar cells 14 and the side of plane of incidence of sunlight 40A, and is bonded on the encapsulant layer 16A. Further, the second optical layer 10B is disposed on the side of a second light-receiving surface 14B of the solar cells 14 and is bonded on the encapsulant layer 16B.

The second optical layer 10B has a substrate layer 110B and a functional layer 120B disposed on the substrate layer 110B. The substrate 110B and the functional layer 120B are respectively the same as the above substrate layer 110A and functional layer 120A, and their description is omitted.

In the embodiment 3, the functional layer is preferably a functional layer in which the matrix is a fluororesin, a silicone resin or a sintered product obtained by sintering a glass frit composition.

Details of the respective layers in the embodiment 3 are the same as in embodiment 1, and their description is omitted.

The present solar cell module has been described with reference to Figs. 2, 4 and 5. The present solar cell module is not limited to the above embodiments. That is, the present solar cell module may have at least one optional layer (such as an adhesive layer or an air layer) within a range not to impair the effects of the present invention. Further, the present solar cell module is not limited so long as the present optical layer is disposed on the side of plane of incidence of sunlight of the solar cells, and the other lamination order is not limited.

For example, the present solar cell module may have an optional layer between the present optical layer and the encapsulant layer. Further, in the present solar cell module, the solar cells may not be encapsulated in the encapsulant layer.

In a case where a glass plate is used as the substrate layer, in view of the design of the present solar cell module and adhesion between the encapsulant layer and the optical layer, the embodiment 1 is particularly preferred.

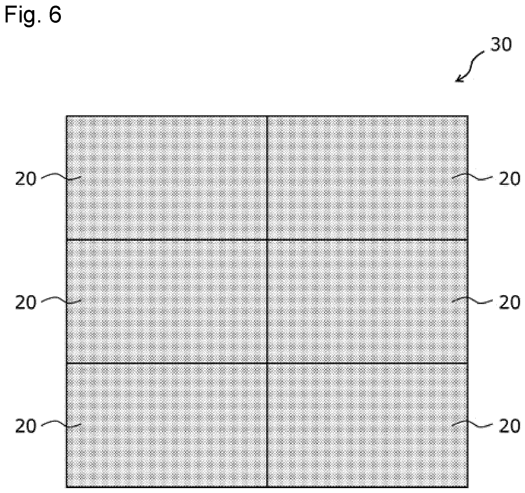

Fig. 6 is a plan view schematically illustrating an example of a solar cell array constituted by the present solar cell modules.

As shown in Fig. 6, a solar cell array 30 is constituted by a plurality of rectangular solar cell modules 20 aligned in a plane and connected in series or in parallel.

The installation site of the solar cell array of the present invention may, for example, be specifically the rooftop, the roof or the outer wall (for example, a wall surface or a window) of a building.

The solar cell array of the present invention, which is excellent in the design and the weather resistance, is preferably used for an outer wall material of a building (for example, a wall surface or a window of a building). Fig. 6 shows an embodiment in which the solar cell array of the present invention is rectangular, however, the shape of the solar cell array of the present invention is not particularly limited.

The outer wall material for building of the present invention comprises the present solar cell module described above. Accordingly, the outer wall material for building of the present invention is excellent in the weather resistance, the design and the power generation efficiency. The outer wall material for building may, for example, be specifically a curtain wall, a wall material or a window.

The building of the present invention comprises a solar cell module, and an optical layer disposed on the side of plane of incidence of sunlight of the solar cell module.

The solar cell module in the building of the present invention is not limited, and may be a solar cell module provided with the present optical layer, or may be a standard solar cell module not having the present optical layer. The solar cell module in the building of the present invention is preferably a standard solar cell module in view of the power generation efficiency of the solar cell module. The solar cell module is typically a solar cell module comprising solar cells, an encapsulant layer encapsulating the solar cells, a surface protective layer disposed on the side of plane of incidence of sunlight of the solar cells, and a rear protective layer disposed on the opposite side of the solar cell from the plane of incidence of sunlight. The standard solar cell module may be a single-sided light-receiving type or double-sided light-receiving type.

The building of the present invention specifically has, on the side of plane of incidence of sunlight of the outer wall material for building having the solar cell module, the present optical layer optionally via an intermediate gas layer. That is, the building of the present invention is a building having a double skin system, and comprises the present optical layer as an outer skin.

The building of the present invention is excellent in the design and is also excellent in the weather resistance, whereby the design of the building is maintained. Further, since electric power can be supplied by photovoltaic power generation, energy saving is accelerated.

The optical layer in the building of the present invention is the same as the above optical layer of the present invention, and its details are omitted.

The optical layer of the present invention according to an embodiment is an optical layer comprising a functional layer containing at least one type of inorganic pigment and a matrix in which the inorganic pigment is dispersed, and a substrate layer comprising a glass plate, and having the functional layer laminated on at least one surface of the substrate layer, wherein the inorganic pigment has a maximum near infrared reflectance in a near infrared region at a wavelength of from 780 to 1,500 nm of at least 50%, an average particle size of from 5.0 to 280.0 nm and a specific surface area of from 5.0 to 1,000 $m^2/g$.

The optical layer of the present invention, which is likely to selectively transmit near infrared light, is useful also as a protective layer of an equipment having an infrared sensor, an element for constituting a member to introduce LiDER (Light Detection and Ranging) system, etc.

According to the present invention, an optical layer having a power generation efficiency of at least 25% (more preferably at least 30%, particularly preferably at least 40%) obtained by the evaluation method described in Examples and being excellent in the design and the weather resistance described in Examples, can be obtained.

EXAMPLES

Now, the present invention will be described in further detail with reference to Examples. However, it should be understood that the present invention is by no means restricted to specific Examples. Ex. 1 to 8, 14, 15 and 17 to 25 are Examples of the present invention, and Ex. 9 to 13 and 16 are Comparative Examples.

[Ex. 1]

<Production of composition (1)>

A polymer solution F (a xylene solution of a chlorotrifluoroethylene/vinyl ether copolymer ("LF-200" manufactured by AGC Inc., polymer concentration: 60 mass%, fluorine atom content of polymer: 27 mass%, hydroxy value: 52 mg-KOH/g) (7.32 g), xylene (3 g), a 1 ppm xylene solution of dibutyltin dilaurate (0.31 g) and an inorganic pigment (1.9 g) were added, and further 13 g of glass beads having a diameter of 1 mm were added, followed by stirring by a kneading machine (Awatori Rentaro, manufactured by THINKY CORPORATION) at 2,000 rpm for 20 minutes. Then, a curing agent (CORONATE HX, manufactured by TOSOH CORPORATION) (0.81 g) was added, followed by stirring at 2,000 rpm for one minute, and the glass beads were removed, to obtain composition (1-1).

<Production of optical layer>

On one surface of a soda lime silicate glass plate (manufactured by AGC Inc., 100 mm × 100 mm) having an average plate thickness of 3.2 mm, the composition (1-1) was applied by an applicator. Then, the composition (1-1) was dried by heating in a thermostatic chamber at 25°C for one week, to obtain optical layer (1-1) comprising a substrate layer comprising the glass plate and a functional layer (average thickness: 46 $\mu$m, matrix: fluororesin) laminated on the substrate layer.

[Ex. 2 to 13]

In the same manner as in Ex. 1 except that the type of the pigment was changed as identified in Table 1, functional layer-forming compositions (1-2) to (1-13) and optical layers (1-2) to (1-13) were obtained.

In Ex. 6, as the inorganic pigment, a Co-Al composite oxide (1.9 g) and titanium oxide (0.57 g) were used. In Ex. 7, as the inorganic pigment, a Co-Al composite oxide (1.9 g) and zirconium oxide (0.57 g) were used. Titanium oxide and zirconium oxide are a white inorganic pigment having a minimum visible reflectance of at least 40%.

In Ex. 13, no pigment was added.

[Ex. 14]

In the same manner as in Ex. 5 except that a white inorganic pigment was added in a content as identified in Table 2, composition (1-14) and optical layer (1-14) were obtained.

[Ex. 15]

In the same manner as in Ex. 14 except that the type of the white inorganic pigment was changed as identified in Table 2, composition (1-15) and optical layer (1-15) were obtained.

In Table 2, the inorganic pigment A is a colored inorganic pigment, and the inorganic pigment B is a white inorganic pigment. In Table 2, the "content" is a proportion (mass%) of the white inorganic pigment to the total mass of the colored inorganic pigment.

[Ex. 16]

In the same manner as in Ex. 1 except that the inorganic pigment was changed to an organic pigment as identified in Table 1, composition (1-16) and optical layer (1-16) were obtained.

[Ex. 17]

<Production of composition (2)>

Denatured ethanol (manufactured by Japan Alcohol Trading Co., Ltd., SOLMIX (registered trademark) AP-11, mixed solvent containing ethanol as the main component) (0.20 g), distilled water (18.7 g), phenyltriethoxysilane (manufactured by Shin-Etsu Silicone, KBE-103) (11.5 g), methyltrimethoxysilane (manufactured by Shin-Etsu Silicone, KBM-13) (26.1 g), a sol containing scaly silica particles (manufactured by AGC Si-Tech Co., Ltd., SUNLOVELY LFS-HN050, concentration of scaly silica particles: 15 mass%, average maximum particle size of scaly silica particles: 0.5 $\mu$m, thickness of silica primary particles: 2.5 nm, aspect ratio of silica primary particles: 200) (38.9 g) and an inorganic pigment (3.84 g) were mixed in this order and stirred for 30 minutes. To the obtained solution, an aqueous nitric acid solution (nitric acid concentration: 10 mass%) (0.72 g) was added, followed by stirring for 60 minutes to obtain composition (2-1).

<Formation of optical layer>

On one surface of a soda lime silicate glass plate (manufactured by AGC Inc., 100 mm × 100 mm) having an average plate thickness of 5.0 mm, the composition (2-1) was applied by an applicator. Then, the composition (2-1) was dried by heating at 150°C for 10 minutes and cured to obtain optical layer (2-1) comprising a substrate layer comprising the glass plate and a functional layer (average thickness: 60 $\mu$m, matrix: silicone resin, volume fraction of scaly silica particles in functional layer: 24%) laminated on the substrate layer.

[Ex. 18]

<Production of composition (3)>

A glass powder containing, as calculated as oxides, BaO (31%), $B_2O_3$ (25%) and ZnO (13%) (thermal expansion coefficient: 105 × 10$^{-7}$/°C, 50% particle diameter (D50): 4.7 $\mu$m, softening point: 530°C) (22.5 g), cordierite (50% particle diameter (D50): 2.5 $\mu$m, 90% particle diameter (D90): 4.6 $\mu$m) (6.8 g) as a thermal expansion coefficient-adjusting agent, ethyl cellulose (1.2 g) as a binder, 2,2,4-trimethylpentane-1,3-diol monoisobutyrate (6.3 g) and ethylene glycol mono-2-ethylhexyl ether (2.5 g) as organic solvents, and an inorganic pigment (2.7 g) were mixed by a kneading machine (Awatori Rentaro, manufactured by THINKY CORPORATION) and dispersed by a three-roll mill to obtained composition (3-1).

<Formation of optical layer>

On one surface of a soda lime silicate glass plate (manufactured by AGC Inc., 100 mm × 100 mm) having an average plate thickness of 3.2 mm, the composition (3-1) was applied by an applicator. After application, the composition (3-1) was dried by heating at 120°C for 25 minutes to remove the organic solvents, then dried by heating at 370°C for 30 minutes to remove the binder, and further dried by heating at 600°C for 10 minutes to sinter the composition (3-1) to obtain optical layer (3-1) comprising a substrate layer comprising a glass plate and a functional layer (average thickness: 50 $\mu$m, matrix: sintered product obtained by sintering the glass frit composition) laminated on the substrate layer.

[Pigment used in Ex.]

    Ex. 1: "Daipyroxide TM Blue #3490E" (trade name manufactured by Dainichiseika Color & Chemicals Mfg. Co., Ltd., colored inorganic pigment)
    Ex. 2: "Daipyroxide TM Red #8270" (trade name manufactured by Dainichiseika Color & Chemicals Mfg. Co., Ltd., colored inorganic pigment)
    Ex. 3: "Cappoxyt Yellow 4214X" (trade name manufactured by Cappelle, colored inorganic pigment)
    Ex. 4: "Sicotrans Red L2817" (trade name manufactured by BASF, colored inorganic pigment)
    Ex. 5: "Blue CR4" (trade name manufactured by ASAHI KASEI KOGYO CO., LTD., colored inorganic pigment)
    Ex. 6: "Blue CR4" (trade name manufactured by ASAHI KASEI KOGYO CO., LTD., colored inorganic pigment) and titanium oxide (manufactured by C.I. Kasei Co., LTD., white inorganic pigment)

Ex. 7: "Blue CR4" (trade name manufactured by ASAHI KASEI KOGYO CO., LTD., colored inorganic pigment) and zirconium oxide (manufactured by Aldrich, white inorganic pigment)

Ex. 8: zirconium oxide (trade name manufactured by Aldrich, white inorganic pigment)

Ex. 9: "Daipyroxide TM Black #3550" (trade name manufactured by Dainichiseika Color & Chemicals Mfg Co., Ltd., colored inorganic pigment)

Ex. 10: "42-250A" (trade name manufactured by Tokan Material Technology Co., Ltd., colored inorganic pigment)

Ex. 11: Iron oxide (trade name manufactured by JUNSEI CHEMICAL CO., LTD., colored inorganic pigment)

Ex. 12: Yellow iron sesquioxide (trade name manufactured by JUNSEI CHEMICAL CO., LTD., colored inorganic pigment)

Ex. 14: "Blue CR4" (trade name manufactured by ASAHI KASEI KOGYO CO., LTD., colored inorganic pigment) and zinc oxide (manufactured by SAKAI CHEMICAL INDUSTRY CO., LTD., white inorganic pigment)

Ex. 15: "Blue CR4" (trade name manufactured by ASAHI KASEI KOGYO CO., LTD., colored inorganic pigment) and "MIZUKASIL P-526" (trade name manufactured by MIZUSAWA INDUSTRIAL CHEMICALS, LTD., white inorganic pigment)

Ex. 16: Organic pigment

Ex. 17: "Blue CR4" (trade name manufactured by ASAHI KASEI KOGYO CO., LTD., colored inorganic pigment)

Ex. 18: "Blue CR4" (trade name manufactured by ASAHI KASEI KOGYO CO., LTD., colored inorganic pigment)

[Evaluation method]

The methods for measuring physical properties are as described above.

More detailed measurement methods and conditions will be described below.

(Inorganic pigment)

<Average particle size>

A sample to be measured (e.g. the inorganic pigment) was poured into distilled water in a concentration of 0.1 mass%, and a dispersing agent (Poiz 532A, manufactured by Kao Corporation) was added in an amount of 1 mass% to the solid content to obtain a slurry. The obtained slurry was subjected to ultrasonic treatment by a table ultrasonic cleaning machine (1510 J-MT, manufactured by Branson Ultrasonics, Emerson Japan Ltd.) for 6 hours, and 10 minutes, 30 minutes and then every 30 minutes after initiation of the ultrasonic treatment, the volume-based cumulative 50% diameter (D50) was measured by a particle size distribution measuring apparatus (Nanotrac Wave II-EX150, manufactured by MicrotracBEL Corp.). Among the cumulative 50% diameters (D50) at 13 points, the smallest value was taken as the average particle size.

<L* value, a* value and b* value>

The L* value, the a* value and the b* value of the inorganic pigment are calculated from a diffuse reflectance spectrum obtained by measurement by diffuse reflectance method in accordance with JIS Z8781-4: 2013.

The diffuse reflectance spectrum was obtained by measuring the diffuse reflected light at 5 nm intervals within a wavelength range of from 200 to 1,500 nm, by holding a sample to be measured (e.g. the inorganic pigment) in a glass holder having a depth of 0.5 mm and covering the sample with a quartz cover by using a spectrophotometer (U-4100, manufactured by Hitachi High-Technologies Corporation). As a reference, barium sulfate (reagent, manufactured by KANTO CHEMICAL CO, INC.) was used.

<Maximum near infrared reflectance and minimum visible reflectance>

As the maximum near infrared transmittance and the minimum visible reflectance of the inorganic pigment, the maximum reflectance at a wavelength of from 780 to 1,500 nm and the minimum reflectance at a wavelength of from 400 to 780 nm were calculated from the above diffuse reflectance spectrum.

(Average visible transmittance, average linear visible transmittance and average near infrared transmittance of optical layer)

The total reflectance of the optical layer was measured at 5 nm intervals within a wavelength range of from 380 to 1,500 nm at a scanning rate of 1,200 nm/min by using a spectrophotometer (manufactured by Hitachi High-Technologies Corporation, trade name: U-4100).

The optical layer was placed so as to be in contact with a light-receiving part of an integrating sphere, and set so that light entered from the surface of the optical layer.

The light source switching was automatic, the switching wavelength was 340.0 nm, the slit was fixed at 8 nm, and the sampling interval was 5 nm.

Further, there was no detector switching correction, the detector switching wavelength was 850.0 nm, the scanning speed was 750 nm/min, the slit was automatically controlled, the Pbs sensitivity was 2, and the light control mode was fixed.

The average linear visible transmittance was obtained as the arithmetic mean of the linear transmittances at 5 nm intervals in a visible region at a wavelength of from 400 to 780 nm in the total transmittance obtained by the above measurement.

The average near infrared transmittance was obtained as the arithmetic mean of the transmittances at 5 nm intervals in a near infrared region at a wavelength of from 780 to 1,500 nm in the total transmittance obtained by the above measurement.

(Power generation efficiency 1)

Taking the power generation contribution degrees of the visible light (400 to 780 nm) and the near infrared light (780 to 1,500 nm) of the monocrystalline silicon cell being 30% and 70%, respectively, the average visible transmittance and the average near infrared transmittance were multiplied and added, to calculated the power generation efficiency of the monocrystalline silicon cell using a soda lime silicate glass plate (manufactured by AGC Inc.) having an average plate thickness of 3.2 mm.

(Design)

The design of the optical layer obtained by the above Ex. was evaluated based on the following standard from the average linear visible transmittance obtained in accordance with the above method. The lower the average linear visible transmittance, the more excellent the shielding properties and the more excellent the design.

<Evaluation standard>

A: The average linear visible transmittance being less than 20%.
B: The average linear visible transmittance being at least 20% and less than 40%.
C: The average linear visible transmittance being at least 40%.

(Weather resistance)

An accelerated weathering test was conducted in accordance with JIS K5600-7-7 using Accelerated Weather Tester (manufactured by Q-PANEL LAB PRODUCTS, model QUV/SE). The functional layer surface of the optical layer was irradiated with ultraviolet light, and a color difference was calculated in accordance with the following formula (1) with respect to the optical layer before the test and the optical layer 2,000 hours after initiation of the test, and evaluation was made based on the following standards.

$$\text{Formula (1)} \quad \text{Color difference} = [(\Delta L^*)^2 + (\Delta a^*)^2 + (\Delta b^*)^2]^{1/2}$$

Symbols in the formula have the following meanings.

$\Delta L^*$ is an absolute value of the difference between the $L^*$ value of the optical layer before the test and the $L^*$ value of the optical layer after the test.
$\Delta a^*$ is an absolute value of the difference between the $a^*$ value of the optical layer before the test and the $a^*$ value of the optical layer after the test.
$\Delta b^*$ is an absolute value of the difference between the $b^*$ value of the optical layer before the test and the $b^*$ value of the optical layer after the test.

<Evaluation standards>

A: The color difference obtained in accordance with the formula (1) being less than 1.0.

B: The color difference obtained in accordance with the formula (1) being at least 1.0 and less than 1.30.

C: The color difference obtained in accordance with the formula (1) being at least 1.30.

The obtained results are shown in Tables 1 to 3.

[Table 1]

| | Functional layer | | | | | | | | |
|---|---|---|---|---|---|---|---|---|---|
| | Pigment (inorganic pigment or organic pigment) | | | | | | | | Thickness (µm) |
| | Composition | Maximum near infrared reflectance (%) | Average particle size (nm) | Specific surface area (m²/g) | Density (g/cm³) | L* | a* | b* | |
| Ex. 1 | Co-Al composite oxide | 83.1 | 151.0 | 19.1 | 4.0 | 47.2 | 15.0 | -49.3 | 46 |
| Ex. 2 | Iron oxide | 72.6 | 167.0 | 56.6 | 4.9 | 37.8 | 9.8 | 7.3 | 35 |
| Ex. 3 | Yellow iron sesquioxide | 76.4 | 108.0 | 49.5 | 3.6 | 47.4 | 8.0 | 20.2 | 43 |
| Ex. 4 | Iron oxide | 73.9 | 127.0 | 50.0 | 4.1 | 35.8 | 3.9 | 3.3 | 43 |
| Ex. 5 | Co-Al composite oxide | 82.6 | 128.0 | 50.0 | 4.2 | 44.5 | 19.3 | -48.9 | 48 |
| Ex. 6 | Co-Al composite oxide | 82.6 | 128.0 | 50.0 | 4.2 | 44.5 | 19.3 | -48.9 | 43 |
| | Titanium oxide | 82.8 | 102.0 | 13.9 | 4.2 | 92.4 | -0.6 | 5.0 | |
| Ex. 7 | Co-Al composite oxide | 82.6 | 128.0 | 50.0 | 4.2 | 44.5 | 19.3 | -48.9 | 43 |
| | Zirconium oxide | 82.6 | 131.0 | 11.9 | 5.7 | 100.0 | -0.4 | 1.1 | |
| Ex. 8 | Zirconium oxide | 82.6 | 131.0 | 11.9 | 5.7 | 100.0 | -0.4 | 1.1 | 48 |
| Ex. 9 | Cu-Fe-Mn composite oxide | 7.8 | 107.0 | 22.6 | 4.8 | 32.7 | 0.2 | -0.2 | 48 |
| Ex. 10 | Co-Al composite oxide | 83.4 | 284.0 | 5.5 | 4.1 | 50.8 | 13.5 | -45.5 | 58 |
| Ex. 11 | Iron oxide | 85.0 | 397.0 | 2.5 | 5.2 | 45.0 | 16.0 | 8.2 | 34 |
| Ex. 12 | Yellow iron sesquioxide | 96.0 | 432.0 | 4.7 | 4.3 | 73.0 | 5.9 | 47.7 | 38 |
| Ex. 13 | - | - | - | - | - | - | - | - | 50 |
| Ex. 16 | Organic pigment | - | - | - | - | - | - | - | 44 |

[Table 1] continued

| | | Optical layer | | | | | | | |
|---|---|---|---|---|---|---|---|---|---|
| | | Average visible transmittance (%) | Average near infrared transmittance (%) | L* | a* | b* | Power generation efficiency 1 (%) | Design | Weather resistance |
| Ex. 1 | | 36.9 | 54.6 | 29.5 | 14.8 | -34.3 | 49.3 | A | A |
| Ex. 2 | | 8.2 | 52.6 | 30.5 | 9.1 | 4.5 | 39.3 | A | A |
| Ex. 3 | | 40.2 | 86.0 | 34.3 | 4.8 | 7.9 | 72.3 | A | B |
| Ex. 4 | | 14.9 | 70.7 | 28.6 | 5.6 | 3.9 | 53.9 | A | A |
| Ex. 5 | | 41.4 | 58.9 | 29.4 | 16.1 | -34.9 | 53.7 | B | A |
| Ex. 6 | | 34.6 | 43.5 | 42.6 | 21.5 | -56.8 | 35.9 | A | B |
| Ex. 7 | | 18.1 | 52.5 | 32.0 | 18.5 | -41.7 | 47.1 | A | A |
| Ex. 8 | | 42.2 | 59.2 | 72.5 | 1.1 | -13.1 | 54.1 | A | A |
| Ex. 9 | | 0.0 | 0.0 | 23.5 | 1.6 | -1.4 | 0.0 | A | A |
| Ex. 10 | | 15.3 | 26.0 | 34.6 | 24.5 | -49.7 | 22.8 | A | A |
| Ex. 11 | | 0.0 | 9.0 | 40.5 | 29.3 | 21.9 | 6.3 | A | A |
| Ex. 12 | | 1.8 | 19.0 | 67.0 | 9.0 | 54.0 | 13.8 | A | B |
| Ex. 13 | | 100.0 | 100.0 | - | - | - | 100.0 | C | A |
| Ex. 16 | | 8.5 | 39.0 | 43.4 | 51.7 | 23.3 | 29.8 | A | C |

[Table 2]

| | Functional layer | | | | | | | | | |
|---|---|---|---|---|---|---|---|---|---|---|
| | Inorganic pigment A | Inorganic pigment B | | | | | | | | Thickness (µm) |
| | Composition | Composition | Content (mass%) | Minimum visible transmittance (%) | Reflectance | Average particle size (nm) | Specific surface area (m²/g) | Maximum near infrared reflectance (%) | Density (g/cm³) | |
| Ex. 5 | Co-Al composite oxide | - | - | - | - | - | - | - | - | 48 |
| Ex. 6 | Co-Al composite oxide | Titanium oxide | 30 | 62.6 | 2.50 | 102.1 | 13.9 | 82.8 | 4.2 | 43 |
| Ex. 7 | Co-Al composite oxide | Zirconium oxide | 30 | 100.0 | 2.21 | 131.0 | 11.9 | 100.0 | 5.7 | 43 |
| Ex. 14 | Co-Al composite oxide | Zinc oxide | 100 | 92.4 | 2.00 | 209.0 | 3.0 | 100.0 | 5.6 | 45 |
| Ex. 15 | Co-Al composite oxide | Silicon dioxide | 30 | 81.7 | 1.44 | 197.0 | 14.9 | 81.7 | 2.2 | 38 |

[Table 2] continued

| | | Optical layer | | | | | |
|---|---|---|---|---|---|---|---|
| | | Average near infrared transmittance (%) | L* | a* | b* | Power generation efficiency 1 (%) | Design | Weather resistance |
| Ex. 5 | | 58.9 | 29.4 | 16.1 | -34.9 | 53.7 | B | A |
| Ex. 6 | | 43.5 | 42.6 | 21.5 | -56.8 | 35.9 | A | B |
| Ex. 7 | | 52.5 | 32.0 | 18.5 | -41.7 | 47.1 | A | A |
| Ex. 14 | | 41.2 | 44.1 | 22.1 | -58.9 | 33.7 | A | A |
| Ex. 15 | | 63.3 | 28.0 | 14.1 | -32.0 | 57.9 | A | A |

[Table 3]

| | Functional layer | | Optical layer | | | | | | |
|---|---|---|---|---|---|---|---|---|---|
| | Matrix | Thickness ($\mu$m) | Average near infrared transmittance (%) | L* | a* | b* | Power generation efficiency 1(%) | Design | Weather resistance |
| Ex. 5 | Fluororesin | 48 | 58.9 | 29.4 | 16.1 | -34.9 | 53.7 | B | A |
| Ex. 17 | Silicone resin | 60 | 67.0 | 27.0 | 13.7 | -33.5 | 62.2 | A | A |
| Ex. 18 | Sintered product obtained by sintering glass frit composition | 50 | 44.0 | 32.1 | 14.8 | -35.1 | 40.7 | A | A |

It is shown from Tables 1 to 3 that the optical layer comprising the functional layer containing the inorganic pigment and the matrix in which the inorganic pigment was dispersed, the inorganic pigment having a maximum near infrared reflectance in a near infrared region at a wavelength of from 780 to 1,500 nm of at least 50%, an average particle size of at least 5.0 nm and at most 280.0 nm and a specific surface area of at least 5.0 m$^2$/g and at most 1,000 m$^2$/g, was capable of forming a solar cell module excellent in the design, and the power generation efficiency and the weather resistance.

[Ex. 21]

<Production of optical layer>

On one surface of a soda lime silicate glass plate (manufactured by AGC Inc., 100 mm × 100 mm) having an average plate thickness of 3.2 mm, a silane coupling agent (3-isocyanatopropyltriethoxysilane) was applied by an applicator and dried at 120°C for 12 hours to form a primer layer. Then, on the primer layer, the composition (1-5) prepared in Ex. 5 was applied and dried by heating in a thermostatic chamber at 25°C for one week and cured to obtain optical layer (1-5A) comprising a substrate layer comprising the glass plate, the primer layer and a functional layer (average thickness: 46 $\mu$m, matrix: fluororesin) in this order.

[Ex. 22]

In the same manner as in Ex. 21 except that the silane coupling agent was changed to methyltriisocyanatosilane to obtain optical layer (1-5B).

(Warm water resistance)

Each of the optical layers (1-5), (1-5A) and (1-5B) was dipped in warm water at 80°C for 100 hours, and whether the functional layer was peeled from the substrate layer or not was visually confirmed, and evaluation was made based on the following standards. The results are shown in Table 4.

S: No peeling.
A: A peeling area being at most 5%.
B: A peeling area being at least 5%.

[Table 4]

| Ex. | 5 | 21 | 22 |
|---|---|---|---|
| Optical layer | (1-5) | (1-5A) | (1-5B) |
| Warm water resistance | B | A | S |

As shown in Table 4, by using a specific silane coupling agent as the primer, the adhesion of the functional layer to the substrate comprising the glass plate improved.

[Ex. 23]

<Production of solar cell module>

Black back glass, an interlayer (ethylene/vinyl acetate resin, manufactured by Bridgestone Corporation, EVASKY S88), the optical layer (1-3) and solar cells (5BB PERC manufactured by NSP) were laminated and vacuum heat-bonded to obtain solar cell module (1-3) comprising the back glass, the solar cells included in an interlayer (encapsulant layer) and the optical layer (1-3) in this order and having the substrate layer in the optical layer being disposed as the outermost layer of the solar cells.
The solar cell module (1-3) was yellow, and was confirmed to have excellent design such that the solar cells were not visually recognized when visually observed from the optical layer side.

[Ex. 24, 25]

Solar cell modules (1-4) (red) and (1-5) (blue) were obtained in the same manner except that the optical layers (1-4) and (1-5) were used instead of the optical layer (1-3).

(Power generation efficiency 2)

Using a solar simulator, with respect to the solar cell modules (1-3) to (1-5) and high transmission glass, the short circuit current ($I_{sc}$), the open circuit voltage ($V_{oc}$) and the maximum output (Pmax) were obtained. The proportion of Pmax of the solar cell module to Pmax of the high transmission glass (Pmax of solar cell module/ Pmax of high transmission glass $\times$ 100%)) was taken as the power generation efficiency 2.

(Visibility of solar cell)

Whether or not the solar cells were visually recognized when each of the solar cell modules (1-3) to (1-5) when observed from a distance of 1 m was confirmed. A case where the cells were visually recognized was rated as B, and a case where the cells were not visually recognized was rated as A.
The other analysis item was evaluated in the same manner as above. Further, details of the optical layers used in Ex. 23 to 25 are the same as in Ex. 3 to 5. The results are shown in Table 5.

[Table 5]

| | Solar cell module | | |
|---|---|---|---|
| | Optical layer | Power generation efficiency 2 (%) | Cell shielding properties |
| Ex. 23 | (1-3) | 72.3 | A |
| Ex. 24 | (1-4) | 53.9 | A |
| Ex. 25 | (1-5) | 53.7 | A |

It is shown from Table 5 that the solar cell module comprising the optical layer of the present invention is excellent in the design and the power generation efficiency.
The entire disclosures of Japanese Patent Application No. 2017-236991 filed on December 11, 2017, Japanese Patent Application No. 2018-045508 filed on March 13, 2018 and Japanese Patent Application No. 2018-045416 filed on March 13, 2018 including specifications, claims, drawings and summaries are incorporated herein by reference in their entireties.

REFERENCE SYMBOLS

| | |
|---|---|
| 10: | Optical layer |
| 10A: | First optical layer |
| 10B: | Second optical layer |
| 110: | Substrate layer |
| 110A: | First substrate layer |
| 110B: | Second substrate layer |
| 120: | Functional layer |
| 120A: | First functional layer |
| 120B: | Second functional layer |
| 14: | Solar cell |
| 14A: | First light-receiving surface |
| 14B: | Second light-receiving surface |
| 16: | Encapsulant layer |
| 18: | Rear protective layer |
| 20: | Optical layer-provided solar cell module |
| 30: | Solar cell array |
| 40, 40, 40B: | Sunlight |

**Claims**

1. An optical layer comprising a functional layer containing an inorganic pigment and a matrix in which the inorganic pigment is dispersed, to be disposed on the side of plane of incidence of sunlight of solar cells, wherein at least a part of the inorganic pigment is an inorganic pigment having a maximum near infrared reflectance in a near infrared region at a wavelength of from 780 to 1,500 nm of at least 50%, an average particle size of from 5.0 to 280.0 nm and a specific surface area of from 5.0 to 1,000 $m^2$/g.

2. The optical layer according to Claim 1, wherein the optical layer is a colored optical layer, and the above specific inorganic pigment is a colored inorganic pigment.

3. The optical layer according to Claim 2, wherein the colored inorganic pigment is an inorganic pigment having in the L*a*b* color space an L* value of from 5 to 100, an a* value of from -60 to 60, and a b* value of from -60 to 60.

4. The optical layer according to Claim 2 or 3, which further contains a light scattering inorganic pigment (excluding the colored inorganic pigment) having a minimum visible reflectance in a visible region at a wavelength of from 400 to 780 nm of at least 40%.

5. The optical layer according to Claim 4, wherein the light scattering inorganic pigment has a refractive index of from 1.50 to 2.60.

6. The optical layer according to Claim 4 or 5, wherein the light scattering inorganic pigment is an inorganic pigment having an average particle size of from 10.0 to 2,000 nm and a specific surface area of from 2.0 to 1,000 $m^2$/g.

7. The optical layer according to any one of Claims 1 to 6, wherein the matrix is at least one member selected from a fluororesin, a silicone resin, and a sintered product obtained by sintering a glass frit composition.

8. The optical layer according to any one of Claims 1 to 7, which has an average near infrared transmittance of from 10 to 100%, which is a value calculated by simply averaging near infrared transmittances at 5 nm intervals in a near infrared region at a wavelength of from 780 to 1,500 nm.

9. The optical layer according to any one of Claims 1 to 8, which further has a substrate layer, and has the functional layer laminated on at least one surface of the substrate layer.

10. A method for producing an optical layer, which comprises applying, to at least one surface of a substrate layer, a functional layer-forming composition at least containing an inorganic pigment having a maximum near infrared reflectance in a near infrared region at a wavelength of from 780 to 1,500 nm of at least 50%, an average particle size of from 5.0 to 280.0 nm and a specific surface area of from 5.0 to 1,000 $m^2$/g, and at least one member selected from a fluorinated polymer, a silane compound and a glass frit composition, to form a functional layer thereby to form an optical layer comprising the substrate layer and the functional layer disposed on at least one surface of the substrate layer.

11. An optical layer-provided solar cell module, comprising solar cells and the optical layer as defined in any one of Claims 1 to 9, wherein the optical layer is disposed on the side of plane of incidence of sunlight of the solar cells.

12. The solar cell module according to Claim 11, wherein the solar cells are CIS solar cells or CIGS solar cells.

13. An outer wall material for building, comprising the optical layer-provided solar cell module as defined in Claim 11 or 12.

14. A building comprising a solar cell module, and the optical layer as defined in any one of Claims 1 to 9, disposed on the side of plane of incidence of sunlight of the solar cell module.

15. An optical layer, which comprises a functional layer containing an inorganic pigment and a matrix in which the inorganic pigment is dispersed, and a substrate layer comprising a glass plate, and has the functional layer laminated on at least one surface of the substrate layer, wherein at least a part of the inorganic pigment is an inorganic pigment having a maximum near infrared reflectance in a near infrared region at a wavelength of from 780 to 1,500 nm of at least 50%, an average particle size of from 5.0 to 280.0 nm and a specific surface area of from 5.0 to 1,000 $m^2$/g.

Fig. 1

Fig. 2

Fig. 3

Fig. 4

Fig. 5

Fig. 6

## INTERNATIONAL SEARCH REPORT

| International application No. |
|---|
| PCT/JP2018/043281 |

**A. CLASSIFICATION OF SUBJECT MATTER**
Int.Cl. H01L31/048(2014.01)i, C03C17/32(2006.01)i

According to International Patent Classification (IPC) or to both national classification and IPC

**B. FIELDS SEARCHED**

Minimum documentation searched (classification system followed by classification symbols)
Int.Cl. H01L31/042-31/056, C03C17/02-17/32

| Documentation searched other than minimum documentation to the extent that such documents are included in the fields searched | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y<br>A | JP 2010-65201 A (TODA KOGYO CORP.) 25 March 2010, paragraphs [0045]-[0058], [0081], [0088]-[0090] & WO 2010/029757 A1 | 10, 15<br>1-9, 11-14 |
| Y<br>A | JP 2010-116549 A (DAINICHISEIKA COLOR & CHEMICALS MFG. CO., LTD.) 27 May 2010, paragraphs [0048]-[0052] & WO 2010/044393 A1 & CN 102186931 A & KR 10-2011-0084920 A | 10, 15<br>1-9, 11-14 |

☒ Further documents are listed in the continuation of Box C. ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 08 February 2019 (08.02.2019) | 19 February 2019 (19.02.2019) |

| Name and mailing address of the ISA/<br>Japan Patent Office<br>3-4-3, Kasumigaseki, Chiyoda-ku,<br>Tokyo 100-8915, Japan | Authorized officer |
|---|---|
| | Telephone No. |

Form PCT/ISA/210 (second sheet) (January 2015)

EP 3 726 592 A1

# INTERNATIONAL SEARCH REPORT

| International application No. |
|---|
| PCT/JP2018/043281 |

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 2016-180041 A (KANAGAWA-KEN) 13 October 2016, paragraphs [0037]-[0042] (Family: none) | 10, 15<br>1-9, 11-14 |
| A | WO 2016/140331 A1 (TODA KOGYO CORP.) 09 September 2016 (Family: none) | 1-15 |
| A | JP 2013-159496 A (ISHIHARA SANGYO KAISHA, LTD.) 19 August 2013 (Family: none) | 1-15 |
| A | JP 2011-258879 A (TOYO INK SC HOLDINGS CO., LTD.) 22 December 2011 (Family: none) | 1-15 |
| A | JP 2012-149152 A (KUREHA CORPORATION) 09 August 2012 (Family: none) | 1-15 |
| A | WO 2015/153129 A1 (FERRO CORPORATION) 08 October 2015 & US 2017/0015836 A1 & EP 3126460 A1 & CN 106164185 A | 1-15 |
| E, A | WO 2018/216718 A1 (AGC INC.) 29 November 2018 (Family: none) | 1-15 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001047568 A
- JP 2017236991 A
- JP 2018045508 A
- JP 2018045416 A